(19) Europäisches Patentamt
European Patent Office
Office européen des brevets

(11) **EP 2 973 899 B1**

(12) **EUROPÄISCHE PATENTSCHRIFT**

(45) Veröffentlichungstag und Bekanntmachung des Hinweises auf die Patenterteilung:
**16.01.2019   Patentblatt 2019/03**

(51) Int Cl.:
*H01S 5/40* *(2006.01)*          *G02B 27/09* *(2006.01)*
*G02B 27/10* *(2006.01)*          *H01S 5/00* *(2006.01)*
*G02B 27/28* *(2006.01)*          *G02B 27/30* *(2006.01)*
*G02B 27/42* *(2006.01)*          *H01S 3/13* *(2006.01)*
*H01S 3/23* *(2006.01)*          *H01S 3/00* *(2006.01)*

(21) Anmeldenummer: **14711710.5**

(22) Anmeldetag: **12.03.2014**

(86) Internationale Anmeldenummer:
**PCT/EP2014/054860**

(87) Internationale Veröffentlichungsnummer:
**WO 2014/140112 (18.09.2014 Gazette 2014/38)**

(54) **VORRICHTUNG ZUR WELLENLÄNGENKOPPLUNG VON LASERSTRAHLEN**

DEVICE FOR COUPLING WAVELENGTHS OF LASER BEAMS

DISPOSITIF DE COUPLAGE DE LONGUEURS D'ONDE DE RAYONS LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.03.2013   US 201313833974**

(43) Veröffentlichungstag der Anmeldung:
**20.01.2016   Patentblatt 2016/03**

(73) Patentinhaber: **TRUMPF Laser GmbH**
**78713 Schramberg (DE)**

(72) Erfinder:
• **KILLI, Alexander**
  **78647 Trossingen (DE)**
• **TILLKORN, Christoph**
  **78667 Villingendorf (DE)**
• **RIED, Steffen**
  **78628 Rottweil (DE)**
• **NEGOITA, Viorel, C.**
  **Plainsboro, New Jersey 08536 (US)**
• **VETHAKE, Thilo**
  **Cranbury, New Jersey 08512 (US)**
• **STROHMAIER, Stephan**
  **10245 Berlin (DE)**
• **LI, Yufeng**
  **Plainsboro, New Jersey 08536 (US)**
• **AN, Haiyan**
  **Plainsboro Township, New Jersey 08536 (US)**
• **BARNOWSKI, Tobias**
  **Cranbury, New Jersey 08512 (US)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**WO-A1-01/48882          WO-A2-2006/045303**
**WO-A2-2006/116477      US-A1- 2007 002 925**
**US-A1- 2011 216 792**

• CHU X ET AL: "Expansion of the channel number in spectral beam combining of fiber lasers array based on cascaded gratings", OPTICS COMMUNICATIONS, ELSEVIER, AMSTERDAM, NL, vol. 281, no. 15-16, 1 August 2008 (2008-08-01), pages 4099-4102, XP022712478, ISSN: 0030-4018, DOI: 10.1016/J.OPTCOM.2008.04.033 [retrieved on 2008-05-09]
• DANEU V ET AL: "SPECTRAL BEAM COMBINING OF A BROAD-STRIPE DIODE LASER ARRAY IN AN EXTERNAL CAVITY", OPTICS LETTERS, OPTICAL SOCIETY OF AMERICA, US, vol. 25, no. 6, 15 March 2000 (2000-03-15) , pages 405-407, XP000947019, ISSN: 0146-9592

**Beschreibung**

Die vorliegende Erfindung betrifft eine Vorrichtung zur Wellenlängenkopplung von Laserstrahlen mit unterschiedlichen Wellenlängen, umfassend: mindestens eine Laserquelle zur Erzeugung einer Mehrzahl von Laserstrahlen, sowie mindestens eine Überlagerungseinrichtung zur räumlichen Überlagerung der Mehrzahl von Laserstrahlen zur Bildung eines überlagerten Laserstrahls mit mehreren Wellenlängen.

Eine Vorrichtung zur (dichten) Wellenlängenkopplung einer Mehrzahl von Laserstrahlen umfasst eine Laserquelle, die eine Mehrzahl von Laserstrahlen mit unterschiedlichen Wellenlängen für die Überlagerung bzw. die Wellenlängen-Kopplung erzeugt. Die Laserstrahlen werden in einer Überlagerungseinrichtung räumlich überlagert und bilden einen überlagerten Laserstrahl, der mehrere Wellenlängen aufweist. Als Überlagerungseinrichtung können spektral sensitive Elemente beispielsweise in Form von Kantenfiltern dienen. Häufig wird als Überlagerungseinrichtung ein winkeldispersives optisches Element verwendet. An dem winkeldispersiven optischen Element werden die unter unterschiedlichen Winkeln auftreffenden Laserstrahlen aufgrund ihrer jeweils unterschiedlichen Wellenlängen zu einem einzigen Laserstrahl mit einer Mehrzahl von unterschiedlichen Wellenlängen überlagert. Als winkeldispersives optisches Element wird häufig ein reflektierendes oder transmittierendes Gitter verwendet, welches die unter unterschiedlichen Einfallswinkeln auftreffenden Laserstrahlen unter einem gemeinsamen Ausfallswinkel reflektiert oder transmittiert. Die Gitter können z.B. als dielektrische Reflexions-oder Transmissionsgitter, Volumen-Bragg-Gitter ("Volume Bragg Grating", VBG) oder als Gitter auf Grundlage eines Hologramms ("Volume Holographic Grating") ausgeführt sein, wie dies beispielsweise in der EP2523280 A2 beschrieben ist.. Als Überlagerungseinrichtung kann auch ein winkeldispersives optisches Element beispielsweise in Form eines Prismas verwendet werden.

Für die Realisierung der Winkelverteilung bzw. für die Erzeugung von unter unterschiedlichen Winkeln auf das winkeldispersive optische Element auftreffenden Laserstrahlen bestehen verschiedene Möglichkeiten. In der US 6,192,062 B1 ist beispielsweise eine Vorrichtung beschrieben, bei welcher zu diesem Zweck ein abbildendes optisches Element in Form einer Linse verwendet wird. Die Linse wandelt eine Ortsverteilung in einer ersten Brennebene, in welcher eine Mehrzahl von Verstärkerelementen (Laser-Emittern) angeordnet ist, in eine Winkelverteilung in einer zweiten Brennebene um. Die von den Verstärkerelementen an unterschiedlichen Orten in der ersten Brennebene ausgehenden, typischer Weise parallelen Laserstrahlen treffen durch die Ort-zu-Winkel-Transformation wie gewünscht unter unterschiedlichen Winkeln auf das Beugungs-Gitter auf. Die für die Transformation verwendete Linse kann als Zylinderlinse oder ggf. als sphärische Linse ausgebildet sein und wird im folgenden auch Transformationslinse genannt.

Alternativ zur Verwendung eines abbildenden optischen Elements zur Realisierung der Winkelverteilung auf dem winkeldispersiven optischen Element ist es auch möglich, die Strahlrichtung der aus mehreren voneinander beabstandeten Laserquellen austretenden Laserstrahlen so zu verändern, dass diese in einem Überlappungsbereich auf dem winkeldispersiven optischen Element in unterschiedlichen Winkeln auftreffen. Um dies zu erreichen, kann eine Mehrzahl von Linsen verwendet werden, welche die Laserstrahlen der Mehrzahl von Laserquellen aufnimmt und fokussiert, wobei der Abstand (engl. "pitch") zwischen den Linsen sich vom Abstand zwischen den Laserquellen unterscheidet, wie in der WO 2006/116477 A2 näher ausgeführt wird.

Um Laserstrahlen mit unterschiedlichen Wellenlängen für die Überlagerung zu erzeugen, ist eine Wellenlängenstabilisierung erforderlich. Um die Stabilisierung zu realisieren, kann für jeden zu überlagernden Laserstrahl eine Rückkopplung erfolgen, um die jeweilige Wellenlänge des dem Laserstrahl zugeordneten Laser-Emitters zu stabilisieren. Als Rückkopplungselemente können in diesem Fall beispielsweise so genannte Volumen-Bragg-Gitter oder Gitter-Wellenleiter-Spiegel dienen, welche einen Teil der Laserstrahlung in den jeweiligen Laser-Emitter zurückreflektieren. Die Wellenlängenstabilisierung kann auch mittels eines gemeinsamen Rückkopplungselements, beispielsweise mittels eines so genannten chirped Volumen-Bragg-Gitters erfolgen, welches die Stabilisierung mehrerer Laser-Emitter auf unterschiedliche Wellenlängen ermöglicht. Es ist auch möglich, die Rückkopplung direkt in einem jeweiligen Laser-Emitter vorzunehmen, beispielsweise bei der Verwendung eines so genannten "Distributed Feedback"(DFB)-Lasers, bei dem das Rückkopplungselement in Form einer Gitterstruktur dem laseraktiven Medium selbst einbeschrieben ist. Auch kann das Rückkopplungselement bzw. die Gitterstruktur außerhalb der laseraktiven Zone, aber in einem auf demselben Chip integrierten Wellenleiter angeordnet sein, wie dies beispielsweise beim so genannten "distributed Bragg reflector"(DBR)-Laser der Fall ist. Die spektrale Bandbreite eines einzelnen wellenlängenstabilisierten Laserstrahls liegt hierbei in der Regel zwischen ca. 0,1 nm und 0,4 nm.

Die Rückkopplung kann auch mit Hilfe eines Rückkopplungselements erfolgen, welches im Strahlengang des überlagerten Laserstrahls angeordnet ist. Häufig wird als Rückkopplungselement in diesem Fall ein teilreflektives Auskoppelelement verwendet, wobei die gesamte Vorrichtung bis zum Auskoppelelement als Resonator dient (so genannter "external cavity laser"). Bei einer solchen Vorrichtung kann ein Strahlteleskop aus zwei Zylinderlinsen oder aus zwei sphärischen Linsen verwendet werden, wie dies beispielsweise in der US 8,049,966 B2 beschrieben ist. Im Strahlweg des überlagerten Laserstrahls kann auch eine einzelne Linse angeordnet werden, die ungefähr im Abstand ihrer Brennweite vom Auskoppelelement angeordnet ist, wie dies beispielsweise in der US 6,192,062 B1 beschrieben ist.

Zur Erzeugung der Laserstrahlen weist die Laserquelle typischer Weise eine Mehrzahl von Laser-Emittern auf, die als Laserdioden ausgebildet sind. Eine Anzahl von typischer Weise zwischen ca. 5 und ca. 55 oder 60 streifenförmigen Laserdioden können hierbei nebeneinander auf einem gemeinsamen Chip angeordnet werden, der auch als (Laser-)Barren bezeichnet wird. Eine Laserdiode erzeugt typischer Weise einen Laserstrahl, der in einer ersten Richtung (FA("fast axis")-Richtung) vergleichsweise schnell divergiert, d.h. einen großen Abstrahlwinkel von z.B. ca. 40° oder mehr aufweist und in einer zweiten Richtung (SA("slow axis")-Richtung) vergleichsweise langsam divergiert und sich beispielsweise mit einem Abstrahlwinkel von ca. 15° oder weniger ausbreitet. Der von einer jeweiligen Laserdiode emittierte Laserstrahl weist in FA-Richtung eine nahezu beugungsbegrenzte Strahlqualität auf und hat in SA-Richtung zumindest für derzeit bekannte Breitstreifenemitter eine vergleichsweise schlechte Strahlqualität. Die SA-Richtung verläuft typischer Weise in der Ebene des Barrens quer zu den streifenförmigen Laserdioden, die FA-Richtung senkrecht dazu. Die Laserdioden können auf dem Barren in konstantem Abstand ("pitch") zueinander angeordnet sein, es ist aber auch möglich, dass der Abstand zwischen benachbarten Laserdioden des Barrens variiert. Auch das Strahlparameterprodukt der einzelnen Laserdioden bzw. Streifenemitter eines Barrens in SA-Richtung kann variieren, wie dies beispielsweise in der EP 2 088 651 A1 der Anmelderin beschrieben ist. Zur Erzeugung einer Variation des Strahlparameterprodukts können zumindest einige der Streifenemitter in SA-Richtung unterschiedlich breit ausgebildet sein.

Zur Kollimierung der austretenden Laserstrahlen kann auf dem Barren oder von diesem beabstandet eine Zylinderlinse angeordnet werden, um die Laserstrahlen der einzelnen Laserdioden in FA-Richtung zu kollimieren. Mit Hilfe eines mikrooptischen Zylinderlinsen-Arrays kann auch eine Kollimation der einzelnen Laserstrahlen des Barrens in SA-Richtung vorgenommen werden.

Mehrere Laserbarren, die entlang der SA-Richtung nebeneinander angeordnet sind, bilden einen so genannten horizontalen Stapel (engl. "Stack"). Die Diodenbarren können hierbei auf einer gemeinsamen Wärmesenke angeordnet werden, beispielsweise durch das so genannte "Direct Copper Bonding", DCB. In einer DCB-Wärmesenke können gegebenenfalls Kühlkanäle zur Wasserkühlung der Diodenbarren eingebracht sein. Hierbei kann die Wärmesenke besonders dünn ausgebildet werden, was einen geringen Pitch, d.h. einen geringen Abstand zwischen den einzelnen Laser-Emittern, ermöglicht, da durch den geringen thermischen Widerstand ein thermisches Übersprechen der einzelnen Laser-Emitter reduziert wird und daher die Packungsdichte erhöht werden kann.

Es versteht sich, dass auch die Stapelung mehrerer Laserbarren übereinander (d.h. in FA-Richtung) möglich ist, was als vertikaler Stapel bezeichnet wird. Ein solcher vertikaler Stapel kann insbesondere an der Rückseite über eine gemeinsame DCB-Wärmesenke gekühlt werden, wodurch ein hoher Füllfaktor bei der Stapelung der Laserbarren ermöglicht wird. Mehrere Laserbarren können auch bogenförmig angeordnet sein, so dass die Emissionsrichtungen in das Bogeninnere gerichtet sind, wie beispielsweise in der EP 1619765 A1 beschrieben ist.

Aus der US 8,049,966 B2 ist es bekannt, die Laserstrahlung von mehreren übereinander angeordneten Laser-Emittern bzw. Laserbarren eines vertikalen Stacks in der Wellenlänge zu überlagern. In der US 2011/0216417 A1 wird vorgeschlagen, eine Transformationseinrichtung in Form eines optischen Rotators zu verwenden, um die Laserstrahlen der Diodenbarren oder der Laser-Emitter eines horizontalen Stacks beispielsweise um 90° zu drehen und so die Rolle der SA-Richtung und der FA-Richtung zu vertauschen, bevor die Laserstrahlen in der Wellenlänge überlagert werden. Zusätzlich dazu offenbart US2011/0216792 A1 eine Wellenlängenüberlagerung in einem externen Resonator.

In der US 2011/0222574 A1 wird vorgeschlagen, mit Hilfe von zwei Überlagerungseinrichtungen in Form von Gittern eine zweidimensionale Wellenlängen-Überlagerung von Laserstrahlen vorzunehmen, die von einem zweidimensionalen Array von Laserquellen erzeugt werden.

Neben der oben beschriebenen mechanischen Stapelung ist auch eine optische Stapelung der von mehreren Laser-Emittern oder von mehreren Laserbarren erzeugten Laserstrahlen möglich. Zu diesem Zweck wird häufig eine Verkämmungseinrichtung (engl. "interleaver") verwendet. Die Verkämmungseinrichtung kann beispielsweise dafür genutzt werden, die Laserstrahlen eines vertikalen oder horizontalen Stapels von Diodenbarren zu verkämmen, so dass diese in nach der Verkämmung in einer Dimension bzw. Richtung übereinander liegen. Die Verkämmung kann beispielsweise auf eine Weise durchgeführt werden, wie sie in der EP 1601072 A1 beschrieben ist. Es ist auch möglich, die Laserstrahlen von zwei z.B. vertikalen Stacks mit Hilfe von Schlitzspiegeln als Verkämmungseinrichtung zu verkämmen, um den Füllfaktor bzw. den Abstand zwischen den von den einzelnen Diodenbarren erzeugten Laserstrahlen zu reduzieren und diese optisch dichter zu packen. Auch ist es möglich, die Laserstrahlen eines horizontalen Stapels von Diodenbarren, die in SA-Richtung nebeneinander angeordnet sind, mit Hilfe eines ersten Stapels von gegeneinander fächerförmig verdrehten Platten oder Spiegeln in FA-Richtung zueinander zu versetzen und mit Hilfe eines weiteren Stapels von gegeneinander verdrehten Platten oder Spiegeln, welcher z.B. um 90° zum ersten Stapel verdreht angeordnet sein kann, eine Stapelung der Laserstrahlen in FA-Richtung zu erzeugen, wie beispielsweise in der DE 10 2011 016 253 A1 dargestellt ist.

Neben Diodenbarren, die jeweils eine Mehrzahl von Laser-Emittern aufweisen, sind auch so genannte Einzel-Emitter gebräuchlich, d.h. Laserdioden, bei denen nur ein einzelner Emitter auf einem Chip bzw. Barren angeordnet ist. Häufig sind bei einem solchen Einzel-Emitter auch die Kollimationslinsen in FA-Richtung und SA-Richtung auf der Wärmesenke des Chips bzw. zu dieser benachbart angeordnet. Auch aus Einzel-Emittern kann ein Stapel aufgebaut werden. Bei gebräuchlichen Stapeln wird eine Mehrzahl von Einzelemittern auf unterschiedlichen Stufen eines treppenartigen Grundkörpers (Wärmesenke) nebeneinander angeordnet. Die von den Einzelemittern erzeugten, parallel verlaufenden Laserstrahlen können beispielsweise über eine Spiegelanordnung in einer Dimension bzw. Raumrichtung übereinander angeordnet werden.

Bei der Wellenlängen-Überlagerung von Laserstrahlen, die von mehreren Laserbarren erzeugt werden, lässt sich eine vergleichsweise hohe Laserleistung realisieren. Bei einer solchen Überlagerung können die Emitter bzw. Laserdioden eines Laserbarrens dieselbe Wellenlänge aufweisen. Aus der US 8,049,966 B2 ist es beispielsweise bekannt, mehrere horizontale Stacks von Laserbarren übereinander zu stapeln und die von jeweils übereinander angeordneten Barren erzeugten Laserstrahlen in der Wellenlänge zu überlagern. Die Strahlqualität bei einer solchen Überlagerung ist im Vergleich zu einer Überlagerung der Laserstrahlen mehrerer Einzel-Emitter, welche jeweils unterschiedliche Wellenlängen aufweisen, jedoch üblicher Weise geringer. Eine solche Überlagerung der Laserstrahlen, die von mehreren auf einem gemeinsamen Barren angeordneten Laseremittern erzeugt werden, kann beispielsweise realisiert werden, indem vor der Überlagerung eine Drehung der Ausrichtung der Laserstrahlen mittels einer Transformationseinrichtung erfolgt, wie dies beispielsweise in der US 2011/0216417 A1 beschrieben wird. In diesem Fall kann nach der Überlagerung zwar eine hohe Strahlqualität erreicht werden, die Gesamtleistung, die bei einer Wellenlängen-Überlagerung der Laserstrahlen mehrerer Einzel-Emitter erreicht werden kann, ist für einen einzelnen externen Resonator betrachtet aber vergleichsweise geringer.

In beiden Fällen kann der bei der Überlagerung erzeugte Laserstrahl für die weitere Verwendung einer Strahlführung zugeführt werden. Häufig wird der überlagerte Laserstrahl in eine Lichtleitfaser eingekoppelt. Eine Leistungsskalierung vor der Einkopplung ist über räumliches Multiplexing oder Polarisationsmultiplexing möglich. Es kann auch eine weitere grobe spektrale Kopplung mittels dielektrischer Kantenfilter erfolgen, wie dies beispielsweise in der US 8,049,966 B2 näher beschrieben ist. Um eine effiziente Einkopplung des überlagerten Laserstrahls in die Lichtleitfaser sicherzustellen, sollte das Strahlprofil des überlagerten Laserstrahls an den Querschnitt der Lichtleitfaser angepasst werden. Die Anpassung des Strahlprofils kann beispielsweise mit Hilfe von geeigneten Strahlteleskopen erfolgen. Auch ist typischer Weise eine Symmetrisierung der nach der Überlagerung in der Regel unterschiedlichen Strahlqualität in zwei zueinander senkrechten Richtungen erforderlich. Zu diesem Zweck kann eine Strahltransformation des überlagerten Laserstrahls durchgeführt werden, um eine im Wesentlichen symmetrische Strahlqualität für die Einkopplung zu erzeugen. Für die Anpassung des Strahlprofils, d.h. der Intensitätsverteilung des Laserstrahls quer zur Ausbreitungsrichtung, ist auch ein räumliches Multiplexen durch räumliches Nebeneinanderlegen mehrerer überlagerter Laserstrahlen möglich, die z.B. aus mehreren externen Resonatoren ausgekoppelt wurden, vgl. beispielsweise die EP 2 088 651 A1. Auch kann eine Anpassung des Stahlprofils bzw. der Strahlqualität durch eine Polarisationskopplung erfolgen.

Der bzw. die überlagerten Laserstrahlen können in eine Strahlführung, beispielsweise in Form einer Lichtleitfaser, eingekoppelt werden und zum Pumpen eines Lasers, beispielsweise eines Festkörperlasers, genutzt werden. Ein von dem Festkörperlaser erzeugter Laserstrahl oder der von der Vorrichtung zur Wellenlängenkopplung erzeugte Laserstrahl selbst kann beispielsweise zur Materialbearbeitung, insbesondere zum Laserschneiden, zum Laserschweißen, zum Laserbohren, Härten, Umschmelzen, zum Pulverauftrag etc. eingesetzt werden.

Aufgabe der Erfindung

Es ist die Aufgabe der vorliegenden Erfindung, eine Vorrichtung zur Wellenlängenkopplung mit verbesserten Eigenschaften bereitzustellen.

Gegenstand der Erfindung

Die Erfindung wird durch die technischen Merkmale des Anspruchs 1 definiert. Bevorzugte Ausführungsformen sind in den abhängigen Ansprüchen gegeben. Weiterbildungen, Beispiele und/oder andere Ausführungsformen die nicht die technischen Merkmale des Anspruchs 1 beinhalten sind nicht Teil der Erfindung und können entsprechend auch keinen patentrechtlichen Schutzanspruch gewähren.

Eine Vorrichtung zur Wellenlängenkopplung, die nicht der Erfindung entspricht, umfasst: eine im Strahlweg zwischen der Laserquelle und der Überlagerungseinrichtung angeordnete Rückkopplungseinrichtung zur Rückkopplung eines Strahlungsanteils der zu überlagernden Laserstrahlen zurück zur Laserquelle, die ein teilweise reflektierendes winkeldispersives optisches Element, insbesondere ein teilweise reflektierendes Beugungs-Gitter, umfasst bzw. als ein solches ausgebildet ist.

Bei diesem Aspekt wird eine Wellenlängenstabilisierung der zur Erzeugung der Laserstrahlen verwendeten Laser-Emitter nicht wie sonst üblich durch eine Rückkopplungseinrichtung in Form eines Auskoppelspiegels vorgenommen, sondern durch eine zwischen der Laserquelle und der Überlagerungseinrichtung angeordnete Rückkopplungseinrichtung in Form eines teilweise reflektierenden winkeldispersiven optischen Elements, beispielsweise in Form eines teilweise reflektierenden Beugungs-Gitters, welches es ermöglicht, alle an der Überlagerung beteiligten Laser-Emitter auf einmal in der Wellenlänge zu stabilisieren.

Das teilweise reflektierende winkeldispersive optische Element kann für die Wellenlängenstabilisierung einen Anteil der auftreffenden Strahlungsintensität von beispielsweise ca. 10 % reflektieren und ca. 90% transmittieren. Es versteht sich, dass das Verhältnis von transmittierter zur reflektierter Laserstrahlung nicht auf das obige Zahlenbeispiel beschränkt ist; vielmehr kann beispielsweise in Abhängigkeit von der Art der verwendeten Laser-Emitter (z.B. VCSEL) ein größerer oder geringerer Anteil der auftreffenden Strahlungsintensität zur Laserquelle zurück reflektiert werden.

Bei einer Weiterbildung dieses Beispiels weist die Vorrichtung mindestens ein zwischen der Laserquelle und dem winkeldispersiven optischen Element angeordnetes abbildendes optisches Element zur räumlichen Überlagerung der Laserstrahlen der Laserquelle auf dem winkeldispersiven optischen Element auf. Bei dem abbildenden optischen Element kann es sich beispielsweise um eine Linse handeln, welche ungefähr im Abstand der Brennweite von der Laserquelle, genauer gesagt von den typischer Weise in einer gemeinsamen Ebene angeordneten Lichtaustrittsflächen der Laser-Emitter der Lichtquelle angeordnet ist. Das teilweise reflektierende winkeldispersive optische Element ist in diesem Fall in der Regel ebenfalls ungefähr im Abstand der Brennweite der Linse angeordnet. Typischer Weise sind die zu überlagernden Laserstrahlen der Lichtquelle bereits in mindestens einer, in der Regel in zwei Richtungen (SA-Richtung und FA-Richtung) kollimiert. Wie eingangs beschrieben wurde, kann auf diese Weise die Ortsverteilung in der Ebene der Laser-Emitter in eine Winkel-Verteilung im Bereich des winkeldispersiven optischen Elements umgewandelt werden. Die Verwendung eines abbildenden optischen Elements stellt jedoch nur eine von mehreren Möglichkeiten dar, um eine räumliche Überlagerung der von mehreren Laser-Emittern erzeugten Laserstrahlen im Bereich des winkeldispersiven optischen Elements zu erzeugen. Weitere Möglichkeiten für die Umsetzung der Ortsverteilung in der Ebene der Lichtaustrittsflächen der Laser-Emitter in eine Winkelverteilung auf einer winkeldispersiven Überlagerungseinrichtung werden weiter unten näher beschrieben. Diese Möglichkeiten können auch eingesetzt werden, um eine räumliche Überlagerung auf dem als Rückkopplungseinrichtung dienenden winkeldispersiven optischen Element, beispielsweise in Form eines teilweise reflektierenden Beugungs-Gitters zu erzeugen.

Bei einer Weiterbildung ist das teilweise reflektierende Beugungs-Gitter bezüglich der auftreffenden Laserstrahlen unter dem so genannten Littrow-Winkel angeordnet. Bei einer solchen Anordnung stimmt der Einfallswinkel der auftreffenden Laserstrahlung mit dem Ausfallswinkel des reflektierten (bzw. am Gitter gebeugten) Strahlungsanteils überein.

Die Littrow-Bedingung lautet:

$$\sin(\alpha_L) = m_1 \lambda / (2\, g_1) \qquad\qquad\qquad\qquad (1)$$

wobei $\alpha_L$ den Littrow-Winkel, $m_1$ die Beugungsordnung, $\lambda$ die Wellenlänge der Laserstrahlung und $g_1$ die Gitterkonstante des Beugungs-Gitters bezeichnet. Durch die Ort-zu-Winkel-Transformation treffen die von unterschiedlichen Laser-Emittern emittierten Laserstrahlen unter unterschiedlichen Winkeln auf das Beugungs-Gitter. Die Rückkopplung und damit die Wellenlängen-Stabilisierung bzw. das Anschwingen eines Laser-Emitters erfolgt bei derjenigen (diskreten) Wellenlänge, die dem jeweiligen (diskreten) Einfallswinkel des zugehörigen zu überlagernden Laserstrahls auf dem Beugungs-Gitter zugeordnet ist. Typischer Weise wird als reflektierte (bzw. gebeugte) Beugungsordnung die -1. Beugungsordnung verwendet. Bei der -1. Beugungsordnung liegen der einfallende und der reflektierte Laserstrahl bezogen auf die Normalenrichtung bzw. auf das Lot auf derseben Seite. Der nicht gebeugte Strahlungsanteil wird in der Regel ohne Ablenkung bzw. mit einem geringen lateralen Versatz vom Beugungs-Gitter transmittiert.

Die Überlagerung der von dem winkeldispersiven optischen Element der Rückkopplungseinrichtung transmittierten Laserstrahlen kann mit Hilfe eines winkeldispersiven optischen Elements der Überlagerungseinrichtung, beispielsweise mit Hilfe eines Prismas oder mit Hilfe eines Beugungs-Gitters erfolgen. Durch eine Abstimmung der Eigenschaften der beiden winkeldispersiven optischen Elemente aufeinander kann erreicht werden, dass der überlagerte Laserstrahl im Wesentlichen in der gleichen Richtung verläuft bzw. dass der überlagerte Laserstrahl die Überlagerungseinrichtung im Wesentlichen unter dem gleichen Winkel verlässt. Unter "im Wesentlichen gleich" wird hierbei verstanden, dass die Strahldivergenz des überlagerten Laserstrahls um nicht mehr als einen Faktor 10, bevorzugt einen Faktor 5, insbesondere einen Faktor 2, größer ist als die Strahldivergenz eines einzelnen zu überlagernden Laserstrahls.

Bei einer vorteilhaften Weiterbildung weist die Überlagerungseinrichtung ein Beugungs-Gitter auf. Das Beugungs-Gitter kann transmittierend oder reflektierend ausgebildet sein. Das Beugungs-Gitter der Überlagerungseinrichtung kann in unmittelbarer Nachbarschaft zum winkeldispersiven optischen Element der Rückkopplungseinrichtung angeordnet sein. In diesem Fall ist das Beugungs-Gitter in der Regel transmissiv ausgebildet. Insbesondere für den Fall, dass das Beugungs-Gitter in größerem Abstand zum winkeldispersiven optischen Element der Rückkopplungseinrichtung angeordnet wird, kann das Beugungs-Gitter auch reflektierend ausgebildet sein.

Durch eine geeignete Abstimmung der Eigenschaften des Beugungs-Gitters der Überlagerungseinrichtung auf das teilweise reflektierende Beugungs-Gitter der Rückkopplungseinrichtung kann auf überraschend einfache Weise eine räumliche Überlagerung der Laserstrahlen zu einem überlagerten Laserstrahl erfolgen.

Hierbei sind eine Gitterkonstante $g_1$ des teilweise reflektierenden Beugungs-Gitters der Rückkopplungseinrich-

tung und eine Gitterkonstante $g_2$ des Beugungs-Gitters der Überlagerungseinrichtung derart aufeinander abgestimmt, dass der überlagerte Laserstrahl das Beugungs-Gitter der Überlagerungseinrichtung unter einem im Wesentlichen gleichen Ausfallswinkel verlässt. An dem als Überlagerungseinrichtung dienenden Beugungs-Gitter sollen die unter unterschiedlichen Einfallswinkeln auftreffenden Laserstrahlen zu einem gemeinsamen Laserstrahl vereinigt werden, der im Idealfall unter einem einzigen Ausfallswinkel aus dem Beugungs-Gitter austritt, d.h. von diesem reflektiert oder transmittiert wird.

Die Gitterebenen des teilweise transmittierenden Beugungs-Gitters der Rückkopplungseinrichtung und des Beugungs-Gitters der Überlagerungseinrichtung können parallel zueinander ausgerichtet sein. In diesem Fall ist typischer Weise die Bedingung, die bei der Verwendung eines teilweise reflektierenden ersten Beugungs-Gitters zur Erzeugung eines konstanten Ausfallswinkels am zweiten Beugungs-Gitter erfüllt sein muss, für einen Ausfallswinkel von 0° von der Wellenlänge der zu überlagernden Laserstrahlen unabhängig. Durch die Wahl eines solchen Ausfallswinkels kann in diesem Fall sichergestellt werden, dass die vom teilweise reflektierenden Beugungs-Gitter transmittierten Laserstrahlen dispersionsfrei überlagert werden.

Bei einer Weiterbildung gilt für die Gitterkonstante $g_2$ des Beugungs-Gitters der Überlagerungseinrichtung und die Gitterkonstante $g_1$ des teilweise reflektierenden Beugungsgitters der Rückkopplungseinrichtung: $m_2 / g_2 = m_1 / (2 g_1)$, wobei $m_1$ die Beugungsordnung des teilweise reflektierenden Beugungs-Gitters der Rückkopplungseinrichtung und $m_2$ die Beugungsordnung des Beugungs-Gitters der Überlagerungseinrichtung bezeichnet. Als Gitterkonstante wird hierbei der Abstand zwischen benachbarten Gitterstrukturen des typischer Weise als Blaze-Gitter oder als Binär-Gitter ausgebildeten Beugungs-Gitters verstanden. Es ist vorteilhaft, wenn die beiden Beugungsordnungen der Beugungs-Gitter übereinstimmen, d.h. wenn gilt: $m_1 = m_2$.

Die obige Bedingung lässt sich aus der allgemeinen Beziehung zwischen Einfallswinkel $\alpha$ und Ausfallswinkel $\beta$ bei der Beugung an einem Gitter mit den jeweiligen Brechzahlen $n_1$ und $n_2$ in einer Beugungsordnung $m_2$ herleiten, welche wie folgt lautet:

$$\sin (\alpha)\, n_1 + \sin (\beta)\, n_2 = m_2\, \lambda / g_2 \, . \qquad (2)$$

Bei einem reflektierenden Beugungs-Gitter mit Luft als optisch dünnerem Medium gilt $n_1 = n_2 = 1{,}0$. Hieraus folgt Gleichung (1) unter der Voraussetzung, dass Einfallswinkel $\alpha$ und Ausfallswinkel $\beta$ gleich groß sind (für Beugungsordnung $m_1$ und Gitterkonstante $g_1$). Im vorliegenden Fall entspricht der Einfallswinkel $\alpha$ am zweiten Gitter dem Littrow-Winkel $\alpha_L$. Durch Einsetzen der Gleichung (1) in die Gleichung (2) ergibt sich bei einem Ausfallswinkel $\beta$ von 0° und bei Luft als optisch dünnerem Medium (d.h. $n_1 = 1{,}0$) die oben angegebene Bedingung zwischen den Gitterkonstanten $g_1$ und $g_2$.

Für den Fall, dass die Gitterebenen der beiden Beugungs-Gitter nicht parallel sondern unter einem Winkel zueinander angeordnet sind, existiert typischer Weise keine analytische Lösung, welche die (entsprechend modifizierten) Gleichungen (1) und (2) erfüllt. In diesem Fall kann - insbesondere für den Fall, dass die verwendete Wellenlänge deutlich kleiner ist als die Gitterkonstante bzw. der Gitterlinienabstand - eine (näherungsweise) Lösung der entsprechenden Gleichungen erhalten werden, welche die Bedingung erfüllt, dass die unterschiedlichen Wellenlängenanteile überlagert werden und unter einem im Wesentlichen gleichen Winkel aus dem Beugungs-Gitter der Überlagerungseinrichtung austreten.

Bei einer Weiterbildung sind das teilweise reflektierende Beugungs-Gitter der Rückkopplungseinrichtung und das Beugungs-Gitter der Überlagerungseinrichtung als ein gemeinsames optisches Element ausgebildet. Das teilweise reflektierende Beugungs-Gitter ist hierbei typischer Weise an einer ersten Seite eines transmittierenden Grundkörpers ausgebildet, während das in der Regel transmittierende Beugungs-Gitter an einer gegenüber liegenden Seite des Grundkörpers gebildet ist. Wie weiter oben beschrieben wurde, können die Gitterebenen bzw. die beiden Seiten des Grundkörpers, an denen die beiden Beugungs-Gitter gebildet sind, parallel zueinander ausgerichtet sein. Da der Grundkörper aus einem Material mit einem höheren Brechungsindex als die Umgebung gebildet ist, erfolgt eine Brechung und damit eine Winkeländerung der am teilweise reflektierenden Beugungs-Gitter eintretenden zu überlagernden Laserstrahlen, so dass diese unter einem anderen Winkel auf das an der gegenüber liegenden Seite des Grundkörpers gebildete transmissive Beugungs-Gitter auftreffen.

Es gilt:

$$\sin (\alpha)\, (n_1 / n_2)\, n_2 + \sin (\beta)\, n_2 = m_2\, \lambda / g_2 \qquad (2)$$

wobei $n_2$ bzw. $n_1$ die Brechzahl im optisch dichteren Medium (im Grundkörper) bzw. im optisch dünneren Medium (der Umgebung) bezeichnen. Einsetzen von Gleichung (1) in Gleichung (2) liefert eine entsprechend modifizierte Bedingung für die Gitterkonstanten $g_1$, $g_2$, welche es erlaubt, die Eigenschaften der Beugungs-Gitter so aufeinander abzustimmen, dass der überlagerte Laserstrahl das transmittierende Beugungs-Gitter unter einem im Wesentlichen identischen Ausfallswinkel (von 0°) verlässt. Für den typischer Weise vorliegenden Fall, dass es sich bei dem optisch dünneren Medium um Luft handelt, welche einen Brechungsindex von ungefähr $n_1 = 1{,}0$ aufweist, stimmt die hier abgeleitete Beziehung für die Gitterkonstanten $g_1$, $g_2$ mit der oben abgeleiteten Beziehung überein, d.h. es gilt: $m_2 / g_2 = m_1 / (2 g_1)$.

Bei einer weiteren Ausführungsform ist zwischen dem teilweise reflektierenden Beugungs-Gitter der Rückkopplungseinrichtung und dem Beugungs-Gitter der Überlagerungseinrichtung ein Strahlteleskop angeordnet. Das Strahlteleskop ermöglicht es, die beiden ansonsten typischer Weise benachbart zueinander angeordneten Beugungs-Gitter in einem vergleichsweise großen Abstand anzuordnen. Durch das Strahlteleskop können selbstverständlich auch die Abmessungen der Intensitätsverteilung (bzw. der Strahlquerschnitt) der zu überlagernden Laserstrahlen verändert werden. Das Strahlteleskop kann transmissive optische Elemente, z.B. Linsen, und/oder reflektierende optische Elemente, z.B. Spiegel, umfassen. Auch die Verwendung eines einzigen optischen Elements als Strahlteleskop ist möglich. Insbesondere bei der Verwendung des Strahlteleskops kann das Beugungs-Gitter der Überlagerungseinrichtung als reflektierendes Gitter ausgebildet werden, da in diesem Fall der Bauraum ausreichend groß ist, um zu vermeiden, dass der reflektierte überlagerte Laserstrahl auf das teilweise reflektierende Beugungsgitter trifft.

Wird ein Strahlteleskop mit einem Abbildungsmaßstab A zwischen den beiden Beugungs-Gittern eingesetzt, ist es ebenfalls erforderlich, die oben angegebene Bedingung zwischen den Gitterkonstanten zu modifizieren. Für eine dispersionsfreie Überlagerung der Laserstrahlen am Beugungs-Gitter der Überlagerungseinrichtung gilt in diesem Fall: $A \, m_2 / g_2 = m_1 / (2 g_1)$, wobei wie weiter oben beschrieben $m_1$ die Beugungsordnung des teilweise reflektierenden Beugungs-Gitters der Rückkopplungseinrichtung, $m_2$ die Beugungsordnung des Beugungs-Gitters der Überlagerungseinrichtung und A den Abbildungsmaßstab des Strahlteleskops bezeichnen. Vorteilhaft ist auch in diesem Fall die Wahl identischer Beugungsordnungen ($m_1 = m_2$), besonders bevorzugt ist der Fall mit $|m_1| = |m_2| = 1$.

Ein Aspekt der vorliegenden Erfindung betrifft eine Vorrichtung umfassend: eine Rückkopplungseinrichtung zur Rückkopplung eines Strahlungsanteils des überlagerten Laserstrahls zurück zur Laserquelle sowie eine Phasenkorrektureinrichtung zur Phasenkorrektur des zur Laserquelle zurück reflektierten Strahlungsanteils. Wie weiter oben dargestellt wurde, dient die Rückkopplungseinrichtung zur Wellenlängen-Stabilisierung von Laser-Emittern der Lichtquelle, so dass diese Laserstrahlen mit jeweils unterschiedlicher Wellenlänge erzeugen. Bei der Rückkopplung besteht das Problem, dass die zur Lichtquelle zurück reflektierte Laserstrahlung den jeweiligen Laser-Emitter präzise treffen muss, da sich ansonsten die Wellenlängen-Stabilisierung stark verschlechtert und die Bandbreite der emittierten Laserstrahlen deutlich erhöht, bzw. der spektrale Fangbereich reduziert wird und der Laser-Emitter in einem nicht gewünschten Spektralbereich emittiert.

Um die Einkopplung des zur Lichtquelle zurück reflektierten Strahlungsanteils zu verbessern, wird beim vorliegenden Aspekt der Erfindung vorgeschlagen, eine Phasenkorrektur der Wellenfront des überlagerten Laserstrahls vorzunehmen, so dass der zurück reflektierte Strahlungsanteil möglichst präzise in die Laser-Emitter der Laserquelle eingekoppelt werden kann. Um dies zu erreichen, kann insbesondere das Rückkopplungselement, genauer gesagt die reflektierende Oberfläche des Rückkopplungselements, an die Krümmung der Phasenfront des überlagerten Laserstrahls bzw. Strahlenbündels angepasst werden. Im Vergleich zur Länge des Strahlwegs des überlagerten Laserstrahls zwischen der Überlagerungseinrichtung und der Rückkopplungseinrichtung, die typischer Weise im Bereich zwischen ca. 2 cm und ca. 20 cm liegt, ist der Krümmungsradius der Phasenfront typischer Weise um mehr als eine Größenordnung höher, d.h. dieser Radius liegt bei ca. 2 m oder darüber. Die Phasenkorrektureinrichtung kann auch eine Phasenkorrekturplatte aufweisen, welche eine an jedem Ort des Strahlquerschnitts des überlagerten Laserstrahls individuell einstellbare Phasenkorrektur ermöglicht.

Bei einer Ausführungsform ist die Überlagerungseinrichtung als Beugungs-Gitter ausgebildet, welches zur Veränderung der Wellenlängen der zu überlagernden Laserstrahlen um eine Drehachse drehbar gelagert ist. Durch die Drehung des Beugungs-Gitters um eine geeignete Drehachse, die typischer Weise senkrecht zur Überlagerungsrichtung verläuft, können auf verblüffend einfache Weise die Wellenlängen der zu überlagernden Laserstrahlen durchgestimmt und geeignet verschoben werden. Das Beugungs-Gitter kann ggf. mittels eines Aktors um die Drehachse gedreht werden. In der Regel ist es aber ausreichend, wenn das Beugungs-Gitter mit Hilfe eines geeignet ausgebildeten Lagers bzw. einer geeigneten Halterung manuell in unterschiedlichen Winkelstellungen relativ zu den zu überlagernden Laserstrahlen zugestellt bzw. fixiert werden kann.

In einer Ausführungsform ist im Strahlweg zwischen der Laserquelle und der Rückkopplungseinrichtung, bevorzugt im Strahlweg zwischen der Überlagerungseinrichtung und der Rückkopplungseinrichtung, ein Polarisationsfilter angeordnet. Der Polarisationsfilter dient der Filterung von unerwünschten Strahlungsanteilen, insbesondere von unerwünschten TM-Moden, die von der Laserquelle erzeugt werden und deren Rückkopplung in die Laserquelle verhindert werden soll. Hierbei wirkt sich günstig aus, dass die von einem jeweiligen Laser-Emitter emittierte Laserstrahlung einen Strahlungsanteil (bzw. Intensitätsanteil) von typischer Weise mehr als ca. 95 % mit einer linearen Polarisation in einer Haupt-Polarisationsrichtung aufweist und nur ein Strahlungsanteil von ca. 5 % nicht entlang der Haupt-Polarisationsrichtung polarisiert ist. Der Anteil der Laserstrahlung, der in Richtung der Haupt-Polarisationsrichtung polarisiert ist, weist gegenüber dem nicht entlang der Haupt-Polarisationsrichtung polarisierten Strahlungsanteil eine höhere Strahlqualität in dem Sinne auf, dass Randfelder (hohe SA-Winkelanteile) weniger stark ausgeprägt sind. Durch das Vorsehen eines Polarisationsfilters, welcher die unerwünschten, nicht in Richtung der Haupt-Polarisationsrichtung polarisierten Strahlungsanteile ausfiltert, kann daher die Strahlqualität des zur Laserquelle zurück reflektierten Strahlungsanteils erhöht werden. Die Anordnung des Polarisationsfilters zwischen der Überlagerungseinrichtung und der Rückkopplungseinrichtung hat sich als günstig erwiesen, da der überlagerte Laserstrahl dort typischer Weise kollimiert ist, was für die Polarisationsfilterung günstig ist.

Bei einer Weiterbildung dieser Ausführungsform sind der Polarisationsfilter und die Überlagerungseinrichtung oder der Polarisationsfilter und die Rückkopplungseinrichtung als gemeinsames optisches Element ausgebildet. Der Polarisationsfilter kann beispielsweise durch das Vorsehen einer geeigneten dielektrischen Beschichtung an der Rückkopplungseinrichtung bzw. der Überlagerungseinrichtung realisiert werden. Es versteht sich, dass die Kombination von Polarisationsfilter und Rückkopplungs- bzw. Überlagerungseinrichtung auch auf andere Weise als durch eine dielektrische Beschichtung erfolgen kann.

Bevorzugt sind ein Phasenkorrekturelement der Phasenkorrektureinrichtung und die Rückkopplungseinrichtung als gemeinsames optisches Element ausgebildet. Das gemeinsame optische Element kann insbesondere eine sphärische oder zylindrische Krümmung aufweisen, welche an die (mittlere) Krümmung der Wellenfront des überlagerten Laserstrahls angepasst ist. Zusätzlich können ggf. ortsabhängig über den Strahlquerschnitt variierende Abweichungen von der mittleren Krümmung der Wellenfront mit einem weiteren Phasenkorrekturelement, beispielsweise mittels der oben erwähnten Phasenkorrekturplatte, korrigiert werden.

Bei einer weiteren Ausführungsform ist die Rückkopplungseinrichtung als Auskoppelelement mit einer den überlagerten Laserstrahl teilweise reflektierenden Oberfläche ausgebildet. Wie weiter oben dargestellt wurde, bildet das Auskoppelelement zusammen mit der Laserquelle bzw. mit den Emittern einen (externen) Resonator. Wie bei herkömmlichen externen Resonatoren üblich, reflektiert das Auskoppelelement einen ersten Strahlungsanteil und transmittiert einen zweiten Strahlungsanteil, der z.B. in eine Lichtleitfaser eingekoppelt werden kann. Bei herkömmlichen externen Resonatoren ist die teilweise reflektierende Oberfläche des Auskoppelelements plan ausgebildet und kann beispielsweise durch eine teilweise reflektierende Lichteintrittsfläche der Lichtleitfaser gebildet werden.

Bei einer Weiterbildung weist die teilweise reflektierende Oberfläche des Auskoppelelements eine (in der Regel konkave) Krümmung auf und ist bevorzugt zylindrisch oder sphärisch ausgebildet. Die Krümmung der teilweise reflektierenden Oberfläche ist typischer Weise an die in der Regel zylindrische oder sphärische Krümmung der Phasenfront des überlagerten Laserstrahls angepasst. Bei der zylindrischen Ausbildung der teilweise reflektierenden Oberfläche kann die Rückkopplung in FA-Richtung oder in SA-Richtung optimiert werden.

Für die separate Minimierung der Rückkopplungsverluste in SA-Richtung und in FA-Richtung ist es erforderlich, für die Phasenkorrektur eine unterschiedliche Brechkraft in SA-Richtung und in FA-Richtung zu verwenden. Auch bei einer sphärischen Ausbildung der teilweise reflektierenden Oberfläche kann ggf. die Rückkopplung sowohl in der SA-Richtung als auch in der FA-Richtung optimiert werden, sofern ein weiteres abbildendes optisches Element oder eine Gruppe von Elementen (z.B. ein Strahlteleskop) vorhanden ist. Gegebenenfalls kann die reflektierende Oberfläche auch zwei unterschiedliche Krümmungsradien aufweisen (Kreuzzylinder-Linse bzw. astigmatische Linse). Es versteht sich, dass bei einer Vorrichtung, bei welcher mehrere überlagerte Laserstrahlen erzeugt werden, ein gemeinsames Auskoppelelement für die überlagerten Laserstrahlen verwendet werden kann, an dem mehrere nebeneinander angeordnete und an die Phasenkrümmung angepasste teilweise reflektierende Oberflächen vorgesehen sind (beispielsweise in der Art einer Rasterzeile oder eines Arrays).

Bei einer weiteren Ausführungsform ist das Auskoppelelement zur Strahlformung des ausgekoppelten bzw. transmittierten überlagerten Laserstrahls ausgebildet, d.h. das Auskoppelelement weist eine Brechkraft für den ausgekoppelten überlagerten Laserstrahl auf. Beispielsweise kann zu diesem Zweck eine austrittsseitige Oberfläche des Auskoppelelements eine Krümmung aufweisen und insbesondere als Meniskus-Linse ausgebildet sein. In diesem Fall bildet die (in der Regel konkave) Linsenfläche der Meniskus-Linse die teilweise reflektierende Oberfläche, was beispielsweise durch das Vorsehen einer geeigneten reflektierenden Beschichtung an der Linsenfläche erreicht werden kann. Die dem externen Resonator abgewandte, in der Regel konvexe Linsenfläche dient dazu, den aus der Vorrichtung bzw. dem externen Resonator ausgekoppelten Strahlungsanteil zu kollimieren bzw. dafür zu sorgen, dass die Divergenz-Eigenschaften des ausgekoppelten Strahlungsanteils durch die Krümmung der teilweise reflektierenden Oberfläche nicht bzw. nur geringfügig beeinflusst wird.

Bei einer Weiterbildung weist die Phasenkorrektureinrichtung ein abbildendes optisches Element auf, wobei der Krümmungsradius des abbildenden optischen Elements an den Radius der Phasenkrümmung des überlagerten Laserstrahls angepasst ist und das zur Kollimation des überlagerten Laserstrahls auf die plane, teilweise reflektierende Oberfläche des Auskoppelelements ausgebildet ist. Das kollimierende optische Element kann insbesondere als Kollimationslinse ausgebildet sein, deren Krümmungsradius zur Optimierung der Rückkopplung an die Phasenfront des auftreffenden überlagerten Laserstrahls angepasst ist. Bei dieser Ausführungsform kann das Auskoppelement eine teilweise reflektierende Oberfläche mit planer Geometrie aufweisen, es ist aber auch möglich, dass die teilweise reflektierende Oberfläche zusätzlich eine Krümmung aufweist. Der Krümmungsradius und damit die Brennweite des abbildenden optischen Elements ist aufgrund der Anpassung an den Radius der Phasenkrümmung deutlich (typischer Weise mindestens eine Größenordnung) größer als die Länge des Strahlwegs zwischen der Überlagerungseinrichtung und dem Auskoppelelement. Bei einem Strahlweg von z.B. zwischen ca. 2 cm und 20 cm zwischen Überlagerungseinrichtung und Auskoppelelement liegt die Brennweite des abbildenden optischen Elements in der Regel bei ca. 2 m oder darüber.

Bei einer weiteren Ausführungsform sind die Überlagerungseinrichtung und die Rückkopplungseinrichtung, insbesondere das Auskoppelelement, als ein gemeinsames optisches Element ausgebildet. Das gemeinsame optische Element kann aus einem für die Laserstrahlung transmissiven Grundkörper gebildet sein, an dessen einer Stirnseite eine Überlagerungseinrichtung in Form eines Gitters angebracht ist und an dessen zweiter, gegenüber liegender Stirnseite eine teilweise reflektierende Beschichtung aufgebracht ist, die insbesondere eine (konvexe) Krümmung aufweisen kann. Das gemeinsame optische Element bzw. der Grundkörper können beispielsweise in der Art eines keilförmigen Prismas ausgebildet sein.

In einer Ausführungsform bildet ein erstes im Strahlweg zwischen der Laserquelle und der Überlagerungseinrichtung angeordnetes abbildendes optisches Element gemeinsam mit einem zweiten im Strahlweg zwischen der Laserquelle und der Überlagerungseinrichtung angeordneten abbildenden optischen Element ein Strahlteleskop. Das Strahlteleskop kann zur Erhöhung der Effizienz der Rückkopplung des zur Laserquelle zurück reflektierten Strahlungsanteils dienen. Insbesondere für den Fall, dass eine Überlagerung der Laserstrahlen in FA-Richtung z.B. mit einer Zylinderlinse erfolgt, hat sich ein Strahlteleskop, welches in SA-Richtung wirkt, als günstig erwiesen.

Das Strahlteleskop kann beispielsweise zur Realisierung einer 4f-Abbildung zwischen der Lichtaustrittsebene der Laserquelle in einer Brennebene des ersten abbildenden optischen Elements und einer Rückkopplungseinrichtung in einer Brennebene des zweiten abbildenden optischen Elements dienen. Es versteht sich, dass zur Erhöhung der Effizienz der Rückkopplung an Stelle eines Strahlteleskops auch ein einzelnes optisches Element verwendet werden kann. In diesem Fall kann beispielsweise in dessen erster Brennebene die Lichtaustrittsebene der Laserquelle und in dessen zweiter Brennebene die Rückkopplungseinrichtung angeordnet sein.

Bei einer weiteren Ausführungsform bildet ein im Strahlweg zwischen der Laserquelle und der Überlagerungseinrichtung angeordnetes abbildendes optisches Element gemeinsam mit einem im Strahlweg des überlagerten Laserstrahls angeordneten abbildenden optischen Element ein Strahlteleskop. Das Strahlteleskop kann zur Anpassung des Strahlquerschnitts beispielsweise für die Einkopplung in eine Lichtleitfaser dienen.

Bei einer weiteren Ausführungsform weist die Vorrichtung eine Strahlumlenkungseinrichtung zur Ausrichtung der Laserstrahlen auf einen gemeinsamen Überlappungsbereich der Überlagerungseinrichtung oder der Rückkopplungseinrichtung auf. Die Laserstrahlen können hierbei wie in der eingangs genannten WO 2006/116477 A2 beschrieben durch die Wahl eines unterschiedlichen Abstandes zwischen den Laserstrahlen bzw. den Laser-Emittern und den zugehörigen Kollimationslinsen auf den gemeinsamen Überlappungsbereich der Überlagerungseinrichtung ausgerichtet werden, die in diesem Fall als winkeldispersives optisches Element ausgebildet ist.

Bei einer Weiterbildung dieser Ausführungsform weist die Strahlumlenkungseinrichtung ein Facettenelement mit einer Mehrzahl von Facetten zur Ausrichtung eines jeweiligen Laserstrahls auf den gemeinsamen Überlappungsbereich auf. Es kann ein transmissives Facetten-Element für die Umlenkung genutzt werden, bei dem jedem zu überlagernden Laserstrahl eine Facette für die Ausrichtung zugeordnet ist. Das Facetten-Element weist in diesem Fall typischer Weise einen plattenförmigen Grundkörper mit in der Regel keilförmigen Teilbereichen auf, welche die Facetten bilden. Das Facettenelement kann auch als reflektierendes optisches Element ausgebildet sein, dessen Spiegel-Facetten relativ zu den Laserstrahlen so ausgerichtet sind, dass diese zum gemeinsamen Überlappungsbereich umgelenkt bzw. auf diesen ausgerichtet werden. Zur Optimierung des Füllfaktors kann auch ein Doppel-Facettenelement bzw. es können zwei aufeinander abgestimmte Facettenelemente eingesetzt werden, wobei jeweils zwei der Facetten beispielsweise in der Art eines anamorphotischen Prismenpaars zusammenwirken.

Bei einer weiteren Ausführungsform weist die Strahlumlenkungseinrichtung eine Mehrzahl von Umlenkspiegeln zur Ausrichtung der Laserstrahlen auf den gemeinsamen Überlappungsbereich der Überlagerungseinrichtung auf. In diesem Fall werden die von mehreren Laser-Emittern oder von mehreren Barren zur Überlagerung bereit gestellten Laserstrahlen durch die Umlenkspiegel auf den gemeinsamen Überlappungsbereich ausgerichtet. Es ist günstig, wenn die Weglängen zwischen den Lichtaustrittsflächen der einzelnen Emitter bzw. den Barren und dem gemeinsamen Überlappungsbereich gleich groß sind. Die Bedingung gleicher optischer Weglängen zum Überlappungsbereich kann typischer Weise erfüllt werden, wenn die Position der Umlenkspiegel und die Umlenkwinkel der Umlenkspiegel geeignet gewählt werden. In Abhängigkeit von der Qualität der Kollimation der Laserstrahlen kann ggf. auf die Forderung nach gleichen Weglängen verzichtet werden.

In einer weiteren Ausführungsform umfasst die Vorrichtung eine Transformationseinrichtung zur Umordnung der Laserstrahlen der Laserquelle und/oder zur Drehung der Orientierung der Laserstrahlen der Laserquelle. Wie weiter oben beschrieben wurde, weisen die von der Laserquelle bzw. von den einzelnen Laser-Emittern der Laserquelle erzeugten Laserstrahlen in FA-Richtung bzw. in SA-Richtung eine unterschiedliche Strahldivergenz auf. Insbesondere für die Überlagerung der Laserstrahlen mehrerer Laser-Emitter, die auf einem gemeinsamen Barren bzw. auf mehreren Barren eines horizontalen Stacks angeordnet sind, kann es sich als günstig erweisen, wenn die Orientierung der Laserstrahlen gedreht wird, so dass diese nicht in SA-Richtung sondern in FA-Richtung überlagert werden. Die Transformationseinrichtung kann insbesondere als optischer Rotator ausgebildet sein, beispielsweise wie er in der US 2011/0216417 A1 beschrieben ist, d.h. unter Verwendung von zwei oder mehr Zylinderlinsen, eines Prismas oder mit Hilfe von zwei in der Orientierung um 90° gedrehten Spiegeln. Durch die Änderung der Orientierung der Laserstrahlen kann eine Reduktion der Rückkoppeleffizienz vermieden werden, welche durch eine Durchbiegung eines horizontalen Stapels bzw. eines Barrens verursacht werden.

Die Transformationseinrichtung kann auch eine Umordnung der von den Laser-Emittern erzeugten Laserstrahlen ohne eine Drehung der Orientierung bewirken. Wie weiter oben dargestellt wurde, können die Laserstrahlen eines horizontalen Stapels von Diodenbarren, die in SA-Richtung nebeneinander angeordnet sind, beispielsweise mit Hilfe von zwei Stapeln von gegeneinander verdrehten Platten oder Spiegeln eine Umordnung der Laserstrahlen erzeugen, so dass diese nach der Transformation ohne Änderung der Orientierung in FA-Richtung übereinander angeordnet sind.

Bei einer weiteren Ausführungsform ist eine Kollimationslinse zur Kollimation von mehreren in einer gemeinsamen Ebene verlaufenden, von der Laserquelle emittierten Laserstrahlen unter einem Winkel zu der gemeinsamen Ebene angeordnet und die Kollimationslinse bewirkt gemeinsam mit der zur Drehung der Orientierung der Laserstrahlen ausgebildeten Transformationseinrichtung eine Ausrichtung der Laserstrahlen auf einen gemeinsamen Überlappungsbereich. Bei der Verwendung einer Transformationseinrichtung, welche die Orientierung der Laserstrahlen dreht, kann eine typischer Weise im Strahlengang vor der Transformationseinrichtung angeordnete FA-Kollimationslinse dazu verwendet werden, die Laserstrahlen unter anderen Winkeln als sonst üblich auf die Transformationseinrichtung einzustrahlen, so dass diese nach dem Durchlaufen der Transformationseinrichtung konvergent verlaufen und auf einen gemeinsamen Überlappungsbereich der Überlagerungseinrichtung ausgerichtet sind. Um die Überlagerung zu bewirken, kann die Kollimationslinse unter einem vergleichsweise kleinen Winkel von z.B. ca. 0,5° oder 0,1° gegenüber der gemeinsamen Ebene verkippt werden, in welcher typischer Weise die Laser-Emitter angeordnet sind, welche die Laserstrahlen erzeugen. Die Laser-Emitter können insbesondere auf einem gemeinsamen Laserbarren angeordnet sein.

Eine weitere Möglichkeit zur Überlagerung der Laserstrahlen mit Hilfe von mehreren in FA-Richtung übereinander angeordneten FA-Kollimationslinsen besteht darin, die FA-Kollimationslinsen in der FA-Richtung leicht gegenüber ihrer üblichen Position zu versetzen. Dies hat einen ähnlichen Effekt wie die Verwendung unterschiedlicher Abstände zwischen den Laser-Emittern und den Kollimationslinsen wie dies in der eingangs zitierten WO 2006/116477 A2 beschrieben ist.

In einer weiteren Ausführungsform weist mindestens eine Laserquelle mindestens ein optisches Modul mit einer Mehrzahl von Laser-Emittern zur Erzeugung eines Strahlaustrittsprofils mit einer in einer Richtung nebeneinander angeordneten Laserstrahlen auf. Die Erzeugung eines Strahlprofils, bei dem eine Mehrzahl von zu überlagernden Laserstrahlen entlang einer Richtung nebeneinander angeordnet sind, ist günstig für die Wellenlängen-Überlagerung mittels eines dispersiven optischen Elements. Im einfachsten Fall kann das optische Modul einen Barren aufweisen, auf dem die Laser-Emitter entlang der SA-Richtung nebeneinander angeordnet sind (mechanische Stapelung), um das gewünschte Strahlaustrittsprofil zu erzeugen. Wird in diesem Fall in das optische Modul eine Transformationseinrichtung in Form eines optischen Rotators integriert, kann die Ausrichtung der einzelnen Laserstrahlen im Strahlaustrittsprofil gedreht werden, so dass die Laserstrahlen in FA-Richtung überlagert weden können.

In einer Weiterbildung ist die Mehrzahl von Laser-Emittern des optischen Moduls in einer ersten Richtung und in einer zweiten, zur ersten senkrechten Richtung versetzt zueinander angeordnet. Die Versetzung kann beispielsweise durch das Anordnen der Laser-Emitter auf unterschiedlichen Stufen einer treppenförmigen Stützstruktur, beispielsweise einer treppenförmigen Wärmesenke, erfolgen. Das optische Modul weist zusätzlich eine Strahlumlenkungseinrichtung auf, um das Strahlaustrittsprofil mit der Mehrzahl von in einer Richtung nebeneinander angeordneten Laserstrahlen zu erzeugen. Wie weiter oben dargestellt wurde, können die Laser-Emitter (Einzel-Emitter) auf unterschiedlichen Stufen einer oder mehrerer treppenartiger Wärmesenken angebracht sein, wobei jedem Einzel-Emitter in der Regel jeweils eine eigene Kollimationslinse in SA-Richtung sowie in FA-Richtung zugeordnet ist. Die Strahlumlenkungseinrichtung kann beispielsweise eine Mehrzahl von Umlenkspiegeln aufweisen, die ggf. so in ihrer relativen Lage zueinander verkippt sind, dass diese zur Ausrichtung der Laserstrahlen des optischen Moduls auf einen gemeinsamen Überlappungsbereich dienen können, wie weiter oben beschrieben ist.

Bei einer Weiterbildung sind mindestens zwei optische Module, insbesondere in Form von treppenartigen Stützstrukturen, z.B. von treppenartigen Wärmesenken, übereinander gestapelt. Bei einer solchen vertikalen Stapelbildung kann sich an die oberste Treppenstufe einer Wärmesenke direkt die Unterseite der nächst folgenden Wärmesenke anschließen. Es ist aber auch möglich, zwei oder mehr der Wärmesenken an einem gemeinsamen Träger zu befestigen, so dass die übereinander gestapelten Wärmesenken zueinander beabstandet angeordnet werden können.

Bei einer weiteren Ausführungsform sind mindestens zwei der optischen Module, beispielsweise in Form von treppenartigen Wärmesenken, auf einem gemeinsamen Kreisbogen angeordnet. Die Anordnung der Wärmesenken auf einem Kreisbogen vereinfacht die Ausrichtung der Strahlenbündel der Laserstrahlen der jeweiligen Wärmesenken auf einen gemeinsamen Überlappungsbereich an der Überlagerungseinrichtung. Es versteht sich, dass auch die Anordnung von mehreren Laserbarren auf einem Kreisbogen möglich ist, um die Überlagerung der von diesen erzeugten Laserstrahlen zu vereinfachen bzw. um die von diesen erzeugten Laserstrahlen auf den gemeinsamen Überlappungsbereich auszurichten.

Bei einer Weiterbildung weist die Vorrichtung eine optische Einrichtung zur Erhöhung des Füllfaktors der von zwei oder mehr unterschiedlichen optischen Modulen erzeugten Laserstrahlen auf. Die optische Einrichtung kann auf unterschiedliche Weise ausgebildet werden:

Beispielsweise kann die optische Einrichtung mindestens einen Schlitzspiegel aufweisen. Dies ist insbesondere günstig, wenn die von zwei oder mehr vertikalen Stapeln von optischen Modulen, insbesondere von optischen Modulen mit treppenartigen Wärmesenken, erzeugten Laserstrahlen miteinander verkämmt werden sollen. Für die Verkämmung von Laserstrahlen, die von zwei vertikalen Stapeln von treppenartigen Wärmesenken erzeugt werden, ist es günstig, wenn die von einem jeweiligen Stapel erzeugten Laserstrahlen bzw. Laserstrahlen-Bündel jeweils einen Füllfaktor von annähernd 50 % aufweisen, so dass die Verkämmung in einer solchen Weise erfolgen kann, dass die Lücken, die von den Laserstrahlen des einen Stapels erzeugt werden, von den Laserstrahlen des anderen Stapels gefüllt werden. Die Verkämmung kann auch mit Hilfe von übereinander gestapelten optischen Elementen in Form von plattenartigen Einzelspiegeln erfolgen, die jeweils um einen (in der Regel konstanten) Winkel gegenüber benachbarten Einzelspiegeln verdreht angeordnet sind, wie dies beispielsweise in der EP 2 342 597 B1 beschrieben ist.

Für die Erhöhung des Füllfaktors kann die optische Einrichtung mindestens eine Umlenkeinrichtung insbesondere in Form einer Prismenanordnung aufweisen. Zusätzlich zur Erhöhung des Füllfaktors ist es auch möglich, die Umlenkeinrichtung(en) zu verwenden, um die Laserstrahlen bzw. die Strahlenbündel von mehreren optischen Modulen auf einen gemeinsamen Überlappungsbereich der Überlagerungseinrichtung oder der Rückkopplungseinrichtung auszurichten.

In einer weiteren Ausführungsform weist mindestens ein Laserbarren genau zwei Laser-Emitter auf. Bei diesem so genannten Dual-Emitter werden jeweils zwei streifenförmige Emitter in der SA-Richtung voneinander beabstandet (d.h. mit einer räumlichen Trennung) auf einem gemeinsamen Laserbarren strukturiert. Die von den beiden Emittern erzeugten Laserstrahlen können mit Hilfe einer gemeinsamen FA-Kollimationslinse und von zwei SA-Kollimationslinsen in SA-Richtung getrennt kollimiert werden. Der Abstand zwischen den Laser-Emittern in SA-Richtung kann in diesem Fall beispielsweise zwischen ca. 500 $\mu$m und ca. 2 mm liegen. Nach der Wellenlängen-Kopplung des ersten bzw. zweiten Laser-Emitters mehrerer Barren eines vertikalen Stapels kann beispielsweise durch eine Polarisationskopplung eine Überlagerung in der Wellenlänge überlagerten Laserstrahlen der jeweiligen ersten bzw. zweiten Laser-Emitter erfolgen. Alternativ können auch beide Emitter des Laserbarrens mit Hilfe einer gemeinsamen SA-Kollimationslinse in der SA-Richtung kollimiert werden. In diesem Fall liegt der Abstand zwischen den beiden Emittern typischer Weise im Bereich zwischen ca. 0,1 mm und 1,0 mm.

Bei einer Ausführungsform weist mindestens eine Laserquelle eine Mehrzahl von Laser-Emittern auf, die auf einem gemeinsamen Laserbarren angeordnet sind. Die Verwendung der weiter oben beschriebenen Transformationseinrichtung zur Drehung der Orientierung der Laserstrahlen hat sich im Zusammenhang mit Laserbarren als besonders günstig erwiesen, da in diesem Fall eine Überlagerung der einzelnen Emitter bzw. bei einem horizontalen Stapel eine Überlagerung der Laserstrahlen der einzelnen Emitter aller Barren in FA-Richtung erfolgen kann, wodurch - zumindest theoretisch - die Strahlqualität eines einzelnen Emitters erreicht werden kann. Die Laser-Emitter können auf dem Laserbarren in konstanten Abständen voneinander angeordnet sein, es ist aber auch möglich, die Abstände zu variieren, um ein Übersprechen "crosstalk" zwischen den Laser-Emittern zu vermeiden bzw. zumindest zu reduzieren.

Bei einer Weiterbildung weist der Laserbarren einen Füllfaktor von mehr als 20 %, bevorzugt von mehr als 25 %, insbesondere von mehr als 30 % auf. Der hohe Füllfaktor kann erreicht werden, indem eine größere Anzahl von Laser-Emittern z.B. mit einer vergleichsweise geringen Emitter-Breite auf dem Laserbarren untergebracht werden als dies bei herkömmlichen Laserbarren der Fall ist. Der Füllfaktor bezeichnet hierbei wie allgemein üblich die Breite eines Laser-Emitters bezogen auf den Abstand zweier benachbarter Laseremitter. Für den Fall, dass die Emitter-Breiten der Laser-Emitter des Laserbarrens und die Abstände zwischen den Laser-Emittern variieren, wird für die Berechnung des Füllfaktors der minimale Füllfaktor herangezogen, d.h. der Laser-Emitter mit dem kleinsten Quotienten aus Emitter-Breite und Abstand zum nächsten Nachbarn legt den Füllfaktor fest.

Aus dem Artikel "High-Power Near-Diffraction-Limited Wavelength-Beam-Combined Diode Arrays" von B. Chann et al., 2005 Conference on Lasers & Electro-Optics (CLEO), pp. 431-433, ist der Einsatz von so genannten "Slab-coupled optical waveguide laser (SCOWL)"-Diodenarrays bekannt, weiche eine Beugungsmaßzahl von weniger als $M^2 < 1,35$ erreichen. Dieses so genannte SCOWL-Diodenarray wird jedoch mit einer SA-Kollimationslinse betrieben, so dass nur ein geringer Füllfaktor und entsprechend nur eine geringe Leistung pro Barren erzielt werden kann.

In einer Weiterbildung erfolgt eine von den bisherigen Beispielen abweichende Kopplung der Laserstrahlen in SA-Richtung. Hierbei weisen die Laser-Emitter (bzw. die Streifenemitter) des Laserbarrens eine Breite von 10 $\mu$m oder weniger, bevorzugt von 5 $\mu$m oder weniger auf. Bei Laser-Emittern mit derart geringer lateraler Ausdehnung handelt es sich typischer Weise um so genannte Single-Mode-Emitter, deren spektrale Bandbreite sich aufgrund des aus der geringen Breite resultierenden Strahlparameterprodukts - zumindest theoretisch - auf eine extrem schmale Linienbreite im Pikometer-Bereich stabilisieren lässt. Laserbarren mit solchen Laser-Emittern sind grundsätzlich bekannt, vgl. den Artikel "Singlemode Emitter Array Laser Bars for High-Brightness Applications" von N. Lichtenstein et al., IEEE 19th International Semiconductor Laser Conference, 2004, Conference Digest, pp. 45- 46. Derartige Laserbarren wurden bisher typischerweise in Verbindung mit einem SA-Kollimationslinsenarray eingesetzt, um den optischen Füllfaktor möglichst hoch zu treiben. Der Füllfaktor pro Barren ist dabei jedoch aufgrund eines einzuhaltenden minimalen Abstands der Array-Linsen von ca. 200 $\mu$m auf ca. 3 % bis 5 % limitiert, was die erreichbare Leistung pro Barren entsprechend limitiert. Um den oben angegebenen hohen Füllfaktor zu erreichen, wird auf das Vorsehen von einzelnen SA-Kollimationslinsen verzichtet. Dies kann beispielsweise dadurch erreicht werden, dass ein in SA-Richtung wirkendes Strahlteleskop und eine SA-Transformationslinse oder nur eine SA-Transformationslinse verwendet wird, um die Laserstrahlung auf das dispersive Element zu fokussieren und die Rückkopplungseffizienz zu erhöhen.

Durch die spektrale Stabilisierung auf eine sehr geringe Linienbreite nimmt die Anzahl an durch eine Wellenlängen-Überlagerung in SA-Richtung koppelbaren Laser-Emittern pro Laserbarren zu, so dass trotz abnehmender Leistung pro Laser-Emitter eine hohe Ausgangsleistung pro Wellenlängenband erreicht werden kann. Ein weiterer positiver Effekt, der sich aus der Reduzierung der emittierenden Fläche pro Emitter ergibt, ist die Verbesserung der Strahlqualität (s.o.). Bei der Verwendung von SEAL-Barren kann die spektrale Bandbreite gegenüber herkömmlichen Breitstreifen-Emitter, die in der Regel eine Bandbreite von ca. 0,3 nm bis 0,4 nm aufweisen, deutlich reduziert werden, beispielsweise auf ca. 0,1 nm oder weniger.

Bei einer Weiterbildung weisen die einzelnen Laser-Emitter des Laserbarrens eine Beugungsmaßzahl $M^2$ in SA-Richtung von weniger als 2,0, bevorzugt von weniger als 1,5, insbesondere von weniger als 1,3 auf. Bei Laser-Emittern mit einer solchen Beugungsmaßzahl in SA-Richtung handelt es sich um Single-Mode-Emitter, bei denen die Anzahl an möglichen Lasermoden in SA-Richtung stark eingeschränkt ist, so dass diese auf eine extrem schmale Linienbreite spektral stabilisiert werden können, was sich signifikant auf die spektrale Brillanz auswirkt. Bei einem Single-Mode-Emitter kann es günstig sein, wenn die Emitterlänge vergleichsweise groß ist (z.B. 4 mm oder mehr), da der Effekt des räumlichen Lochbrennens eine spektrale Verbreiterung hervorruft, die invers proportional zur Emitterlänge ist.

Neben den weiter oben beschriebenen Single-Mode-Emittern mit konstanter Streifenbreite können die oben angegebenen Werte für die Beugungsmaßzahl bzw. das Strahlparameterprodukt auch mit einem so genannten Trapezlaser erzeugt werden, bei dem auf einem Halbleiter-Chip sowohl ein schmaler Streifen konstanter Breite, der einen Monomode-Seedbereich bildet, als auch ein sich in Richtung zur Strahlaustrittsfläche trapezförmig erweiternder Verstärkerbereich anschließt. Ein Emitter mit einem Strahlparameterprodukt bzw. einer Beugungsmaßzahl im oben angegebenen Wertebereich kann ggf. auch in Form eines so genannten Z-Lasers oder als Oberflächen-Emitter (z.B. VCSEL, VECSEL) ausgebildet sein.

Bei einer weiteren Ausführungsform umfasst die Vorrichtung zusätzlich eine Strahlformungseinrichtung zur Formung eines von mindestens einem überlagerten Laserstrahl gebildeten Strahlprofils. Die Formung des Strahlprofils ist insbesondere günstig bzw. erforderlich, um die Effektivität der Einkopplung der von der Vorrichtung erzeugten Laserstrahlung in eine Lichtleitfaser zu erhöhen. Aufgrund des typischer Weise runden Querschnitts der Lichtleitfaser ist zu diesem Zweck eine in der Regel symmetrische Strahlqualität vorteilhaft, d.h. ein Strahlparameterprodukt, welches in einer Ebene senkrecht zur Ausbreitungsrichtung ein Aspektverhältnis von ca. 1:1 aufweist.

Um die Strahlqualität zu symmetrisieren bzw. an das Aspektverhältnis bzw. den Querschnitt der Lichtleitfaser anzupassen, weist die Strahlformungseinrichtung bevorzugt eine Einrichtung zur räumlichen Umordnung mit oder ohne Strahlrotation und/oder zur Überlagerung von mehreren überlagerten Laserstrahlen und/oder der mindestens zwei Teilstrahlen auf. Die Einrichtung kann dazu dienen, mehrere von der Überlagerungseinrichtung erzeugte überlagerte Laserstrahlen und/oder mehrere von der Strahlteilereinrichtung erzeugte Teilstrahlen, die an unterschiedlichen Orten des Strahlquerschnitts angeordnet sind, räumlich umzuordnen. Die räumliche Umordnung kann auf unterschiedliche Weise erfolgen. Beispielsweise können zu diesem Zweck Treppenspiegel eingesetzt werden, wodurch eine Umordnung ohne Strahlrotation realisiert werden kann. Eine Strahlformungseinrichtung, welche die Laserstrahlen zum Umordnen rotiert, kann beispielsweise eine Periskop-Anordnung aufweisen.

Bei einer Ausführungsform weist die Strahlformungseinrichtung eine Strahlteilereinrichtung auf, um einen der überlagerten Laserstrahlen in mindestens zwei Teilstrahlen zu zerschneiden. Bei der Strahlteilereinrichtung kann es sich beispielsweise um einen Loch- oder Kantenspiegel handeln, welcher einen äußeren Bereich des Strahlquerschnitts eines einzelnen Laserstrahls reflektiert bzw. abstreift (daher auch Scraper-Spiegel genannt) und einen Bereich des Strahlquerschnitts transmittiert. Als Strahlteilereinrichtung für das Schneiden bzw. das Aufteilen eines überlagerten Laserstrahls in zwei oder mehr Teilstrahlen kann auch ein Plattenstapel mit mehreren fächerförmig gegeneinander verdrehten Platten dienen.

Alternativ oder zusätzlich ist es auch möglich, eine Strahlformungseinrichtung mit einer Strahlteilereinrichtung zu verwenden, die zum Aufteilen eines schräg auftreffenden Laserstrahls zwei planparallele, in geringem Abstand zueinander angeordnete Spiegelflächen aufweist, wie beispielsweise in der US 5,825,551 beschrieben ist. Eine solche Strahlteilereinrichtung ist geeignet, das Strahlparameterprodukt bzw. die Beugungsmaßzahl $M_x^2$, $M_Y^2$ eines (überlagerten) Laserstrahls in zwei zueinander orthogonalen Richtungen x und y zu verändern. Insbesondere können hierbei die beiden Strahlparameterprodukte in den beiden orthogonalen Richtungen aneinander angeglichen werden, was die Effizienz der Einkopplung in die Lichtleitfaser erhöht. Die parallel ausgerichteten reflektierenden Flächen sind derart im Strahlengang angeordnet, dass der Strahldurchmesser des Laserstrahls in der einen Richtung sich durch mehrfache Reflexion zwischen den Platten verringert und in einer zweiten Richtung erhöht. Diese Art der Strahlteilung ist insbesondere günstig, wenn keine Weglängenkompensation erfolgt, da in diesem Fall die von den einzelnen Laser-Emittern ausgehenden Laserstrahlen ggf. nicht präzise genug getrennt sind und sich teilweise überlappen, so dass keine saubere Abbildung erfolgt. Der Einsatz eines Strahlteilers z.B. in Form eines Treppenspiegels könnte in diesem Fall durch ein Überstahlen der Stufen zu großen Verlusten führen, was beim Einsatz von planparallelen Platten verhindert werden kann, da in diesem Fall keine Kanteneffekte auftreten.

Als Einrichtung zur Überlagerung von zwei oder mehr überlagerten Laserstrahlen bzw. Teilstrahlen kann z.B. eine Polarisationskopplungseinrichtung in der Art eines dielektrischen Spiegels oder dergleichen dienen. Die Einrichtung zur Überlagerung, beispielsweise in der Form eines Polarisationskopplers, führt die beiden überlagerten Laserstrahlen bzw. Teilstrahlen zusammen, wodurch sich das Strahlprofil verändert.

Es kann auch eine Transformationseinrichtung zur Veränderung bzw. zur Drehung der Orientierung eines oder mehrerer der überlagerten Laserstrahlen als Teil der Strahlformungseinrichtung dienen. Beispielsweise kann auf diese Weise die Orientierung der überlagerten Laserstrahlen bzw. der Teilstrahlen um 90° gedreht werden, so dass eine horizontale Orientierung des Strahlquerschnitts eines überlagerten Laserstrahls bzw. Teilstrahls in eine vertikale Orientierung umgewandelt werden kann oder umgekehrt. Auch kann die Umordnung mit Hilfe der oben erwähnten Anordnungen erfolgen, welche die Laserstrahlen drehen, um sie räumlich umzuordnen. Die Drehung der Orientierung des bzw. der Laserstrahlen kann beispielsweise mit Hilfe einer den Strahlweg drehenden Einrichtung erfolgen, wie sie in der US 5,513,201 beschrieben ist.

Wie weiter oben dargestellt wurde, kann der bzw. können die überlagerten Laserstrahlen in eine Lichtleitfaser eingekoppelt werden und der überlagerte Laserstrahl kann bzw. die überlagerten Laserstrahlen können direkt bzw. über eine geeignete Strahlführung zur Materialbearbeitung genutzt werden. Gegebenenfalls kann die Laserstrahlung auch zum Pumpen eines weiteren Lasers, beispielsweise eines Festkörperlasers, genutzt werden, der beispielsweise ebenfalls zur Materialbearbeitung eingesetzt werden kann. Die Strahlführung der Pumpstrahlung kann über Absorber, Strahlweichen, Strahlteiler etc. erfolgen. Auch ist es möglich, die Leistung der von der Vorrichtung gelieferten Laserstrahlung zu messen und diese ggf. zu regeln.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1     eine schematische Darstellung einer Vorrichtung zur Wellenlängenkopplung von Laserstrahlen, welche eine teilweise transmittierendes erstes Beugungs-Gitter als Rückkopplungseinrichtung und ein transmittierendes zweites Beugungs-Gitter zur dispersionsfreien Überlagerung der Laserstrahlen aufweist,

Fig. 2     eine Darstellung analog Fig. 1, bei der zwischen dem ersten und dem zweiten Beugungs-Gitter ein Strahlteleskop angebracht ist,

Fig. 3     eine Darstellung analog Fig. 1, bei der das erste und zweite Beugungs-Gitter an einem gemeinsamen transmittierenden Grundkörper angebracht sind,

Fig. 4a,b     schematische Darstellungen einer Vorrichtung zur Wellenlängenkopplung, welche eine Rückkopplungseinrichtung in Form eines Auskoppelelements aufweist, dessen teilweise reflektierende Oberfläche zur Phasenkorrektur des zur Laserquelle zurück reflektierten Strahlungsanteils zylindrisch ausgeformt ist,

Fig. 5a-c     Darstellungen analog Fig. 4a,b, bei welcher ein im Strahlengang vor dem zweiten Beugungs-Gitter angeordnetes Strahlteleskop zur Erhöhung der Rückkopplungseffizienz vorgesehen ist,

Fig. 6a,b     eine Darstellung analog Fig. 4a,b, bei welcher eine Zylinder-Linse als Phasenkorrektureinrichtung dient und ein Strahlteleskop für die Optimierung der Rückkopplung des reflektierten Strahlungsanteils in die Laserquelle vorgesehen ist,

Fig. 7a,b     eine Darstellung analog Fig. 4a,b, bei welcher das Auskoppelelement eine sphärisch gekrümmte teilweise reflektierende Oberfläche aufweist und ein Polarisationsfilter zur Filterung von unerwünschten Strahlungsanteilen bei der Rückkopplung vorgesehen ist,

Fig. 8     eine Darstellung einer Vorrichtung zur Wellenlängenkopplung, bei welcher ein als Überlagerungseinrichtung dienendes Beugungs-Gitter und eine Rückkopplungseinrichtung in Form eines teilweise reflektierenden Auskoppelelements an einem gemeinsamen Grundkörper vorgesehen sind,

Fig. 9     eine Strahlumlenkungseinrichtung in Form eines Facettenelements zur Ausrichtung eines jeweiligen Laserstrahls auf einen gemeinsamen Überlappungsbereich auf der Überlagerungseinrichtung,

Fig. 10     eine Strahlumlenkungseinrichtung, die zur Ausrichtung eines jeweiligen Laserstrahls auf den gemeinsamen Überlappungsbereich eine Mehrzahl von Umlenkspiegeln aufweist,

Fig. 11a,b     eine Strahlumlenkungseinrichtung in einer Draufsicht und einer Seitenansicht, bei welcher mehrere Laserstrahlen eines optischen Moduls über Umlenkspiegel auf den gemeinsamen Überlappungsbereich ausgerichtet werden,

Fig. 12a,b     Strahlumlenkungseinrichtungen mit einer Mehrzahl von optischen Modulen, die zur Ausrichtung der von diesen erzeugten Laserstrahlen auf den Überlappungsbereich auf einem Kreisbogen angeordnet sind,

Fig. 13     eine Mehrzahl von optischen Modulen mit einer Prismenanordnung zur parallelen Ausrichtung der diesen emittierten Laserstrahlen unter Erhöhung des Füllfaktors,

Fig. 14     eine schematische Darstellung einer optischen Einrichtung mit einem Schlitzspiegel zur Verkämmung der von zwei Stapeln von optischen Modulen erzeugten Laserstrahlen,

Fig. 15a,b     eine Transformationseinrichtung zur Drehung der Orientierung einer Mehrzahl von Laserstrahlen, die zur Ausrichtung der Laserstrahlen auf einen gemeinsamen Überlappungsbereich mit einer Kollimationslinse zusammenwirkt,

Fig. 16a,b     Darstellungen von zwei Laser-Emittern, die in geringem Abstand zueinander auf einem gemeinsamen Barren angeordnet sind,

Fig. 17     eine Darstellung eines Laserbarrens mit einer Mehrzahl von streifenförmigen Laser-Emittern,

Fig. 18a-c     Darstellungen von drei unterschiedlichen Ausführungsbeispielen von streifenförmigen Laser-Emittern, die eine unterschiedliche Beugungsmaßzahl aufweisen,

Fig. 19     eine Darstellung einer Strahlformungseinrichtung zur Formung eines von einem überlagerten Laserstrahl gebildeten Strahlprofils.

In der folgenden Beschreibung der Zeichnungen werden für gleiche bzw. funktionsgleiche Bauteile identische Bezugszeichen verwendet.

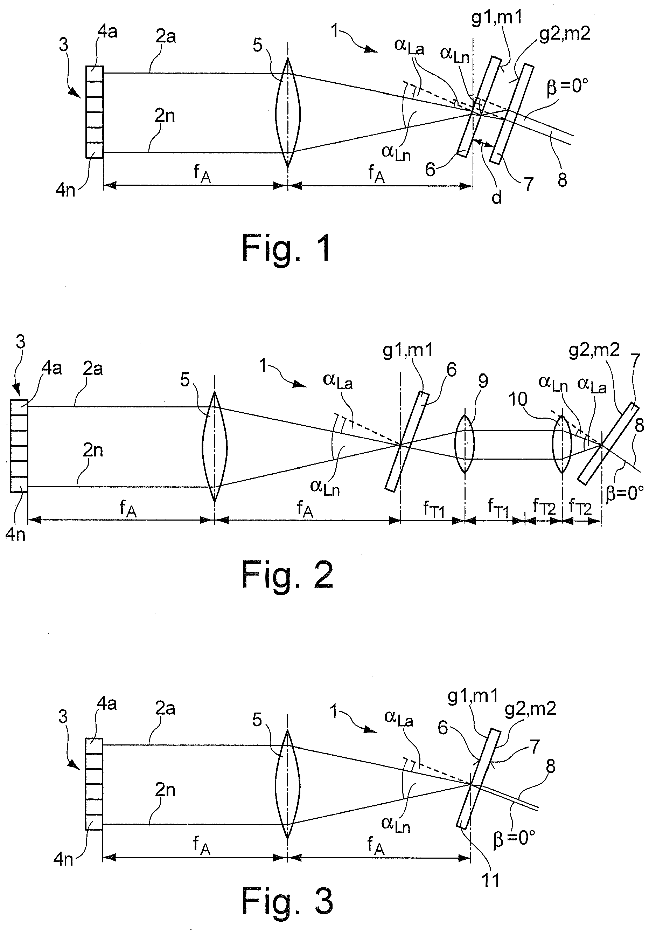

**Fig. 1** zeigt eine Vorrichtung 1 zur Wellenlängenkopplung von Laserstrahlen 2a, ... 2n mit jeweils unterschiedlichen Wellenlängen $\lambda_1$,..., $\lambda_n$, die von einer Laserquelle 3 erzeugt werden. Die Laserquelle 3 weist zur Erzeugung der Laserstrahlen 2a, ..., 2n eine entsprechende Anzahl von Laserbarren 4a, ..., 4n auf, die einen vertikalen Stapel bilden und die über eine (nicht gezeigte) DCB-Wärmesenke an ihrer Rückseite gekühlt werden. Es versteht sich, dass an Stelle von Laserstrahlen 2a, ... 2n, die von unterschiedlichen Laserbarren erzeugt werden, auch Laserstrahlen 2a, ..., 2n überlagert werden können, die von mehreren Emittern erzeugt werden, die auf einem einzelnen Laserbarren angeordnet sind, wobei ggf. eine nicht gezeigte Transformationsoptik verwendet werden kann, um die Orientierung der Laserstrahlen 2a, ..., 2n zu verändern. Die Laserstrahlen 2a, ..., 2n können auch von mehreren Einzel- bzw. Dual-Emittern erzeugt werden, wie weiter unten im Detail dargestellt ist.

Die zu überlagernden kollimierten Laserstrahlen 2a, ..., 2n treffen auf eine Linse 5, welche als Zylinderlinse oder als sphärische Linse ausgebildet sein kann. Die Lichtaustrittsflächen der Laser-Emitter der Laserbarren 4a, ..., 4n liegen in einer gemeinsamen Ebene, die senkrecht zur Zeichenebene verläuft. Die gemeinsame Ebene bildet eine erste Brennebene der Linse 5, d.h. die Linse 5 ist in einem Abstand zu den Lichtaustrittsflächen der Laserbarren 4a, ..., 4n angeordnet, welcher der Brennweite $f_A$ der Linse 5 entspricht. Eine Rückkopplungseinrichtung in Form eines teilweise reflektierenden winkeldispersiven optischen Elements, das im vorliegenden Beispiel als ein erstes, teilweise reflektierendes Beugungs-Gitter 6 ausgebildet ist, ist in einem Abstand zur Linse 5 angeordnet, der im Wesentlichen der Brennweite $f_A$ der Linse 5 entspricht. Bei der Verwendung einer Linse 5 in Form einer Zylinderlinse ist typischer Weise ein (nicht gezeigtes) Strahlteleskop zur Erhöhung der Rückkoppeleffizienz vorgesehen. Bei der Verwendung einer sphärischen Linse 5 kann ggf. auf ein Strahlteleskop für die Rückkopplung verzichtet werden.

Durch die in Fig. 1 gezeigte Anordnung der Linse 5 wird die Ortsverteilung in der Ebene der Lichtaustrittsflächen der Laser-Emitter der Laserbarren 4a, ..., 4n in eine Winkelverteilung auf dem Beugungs-Gitter 6 umgewandelt, d.h. jeder der Laserstrahlen 2a, ..., 2n trifft unter einem unterschiedlichen Winkel $\alpha_{La}$, ..., $\alpha_{Ln}$ auf dem Beugungs-Gitter 6 auf. Das teilweise reflektierende Beugungs-Gitter 6 ist bezüglich der auftreffenden Laserstrahlen 2a, ..., 2n unter dem Littrow-Winkel angeordnet, so dass der Ausfallswinkel des am teilweise reflektierenden Beugungs-Gitter 6 zurück reflektierten Strahlungsanteils eines jeweiligen Laserstrahls 2a, ..., 2n mit dem Einfallswinkel übereinstimmt.

Für jeden der auftreffenden Laserstrahlen 2a, ..., 2n gilt:

$$\sin (\alpha_{Li}) = m_1 \lambda_i / (2 g_1)$$

mit i = a bis n (bzw. 1 bis n), wobei $m_1$ die Beugungsordnung, $\alpha_{Li}$ den Einfallswinkel und $\lambda_i$ die Wellenlänge bezeichnen, für welche die Littrow-Bedingung erfüllt ist und $g_1$ die Gitterkonstante des Beugungs-Gitters 6 bezeichnet. Wie in Fig. 1 zu erkennen ist, sind die beugenden Strukturen an der der Laserquelle 3 abgewandten Seite des Beugungs-Gitters 6 bzw. an dessen transmissivem Grundkörper angebracht. Die oben angegebene Beziehung gilt auch in diesen Fall, da sich der Einfluss der Winkeländerung der Laserstrahlen 2a, ..., 2n beim Eintritt vom optisch dünneren Medium in das optisch dichtere Medium des Beugungs-Gitters 6 und der Einfluss der Änderung der Wellenlängen der Laserstrahlen 2a, ..., 2n im optisch dichteren Medium gegenseitig kompensieren.

Der zu den Laserbarren 4a, ..., 4n zurück reflektierte Strahlungsanteil der auftreffenden Laserstrahlen 2a, ..., 2n ermöglicht eine Wellenlängenstabilisierung in einer schmalen Bandbreite um die jeweilige Wellenlänge $\lambda_i$, die bei-spielsweise bei ca. 0,1 nm bis 0,4 nm liegen kann. Die Eigenschaften des Beugungs-Gitters 6 hinsichtlich des reflektierten bzw. transmittierten Strahlungsanteils können u.a. in Abhängigkeit von der Art der die Laserstrahlen 2a, ..., 2n erzeugenden Laser-Emitter geeignet gewählt werden, um eine effektive Rückkopplung bzw. Wellenlängenstabilisierung zu ermöglichen. Beispielsweise kann ein Strahlungsanteil von ca. 10 % am Beugungs-Gitter 6 reflektiert und ein Strahlungsanteil von ca. 90 % transmittiert werden, was z.B. durch eine geeignete Wahl der Eigenschaften einer an dem Beugungs-Gitter 6 angebrachten, teilweise reflektierenden Beschichtung ermöglicht wird. Bei geeignet optimierten Laserbarren 4a, ..., 4n (z.B. mit speziell angepasster Reflektivität der Front-Facetten und/oder einer geeignet angepassten Länge der Kavität) ist es auch möglich, Beugungs-Gitter 6 mit einer Reflektivität im Bereich zwischen 2-8 % zu verwenden.

Zur Wellenlängen-Überlagerung der Laserstrahlen 2a, ..., 2n, die vom ersten Beugungs-Gitter 6 transmittiert werden, ist in der Vorrichtung 1 eine Überlagerungseinrichtung in Form eines winkeldispersiven optischen Elements angeordnet, welches im vorliegenden Beispiel als (zweites) transmissives Beugungs-Gitter 7 ausgebildet ist. Es ist günstig, wenn das zweite Beugungs-Gitter 7 in unmittelbarer Nähe zum ersten Beugungs-Gitter 6 angebracht ist, d.h. wenn der Abstand d zwischen den parallel zueinander ausgerichteten Beugungs-Gittern 6, 7 bei weniger als ca. 10 mm liegt.

Die Eigenschaften des ersten Beugungs-Gitters 6 und die Eigenschaften des zweiten Beugungs-Gitters 7 sind derart aufeinander abgestimmt, dass der überlagerte Laserstrahl 8 das zweite Beugungs-Gitter 7 unter einem im Wesentlichen gleichen Ausfallswinkel β (im Idealfall unter dem gleichen Ausfallswinkel β) verlässt.

Im vorliegenden Beispiel, bei dem die Beugungs-Gitter 6, 7 parallel zueinander ausgerichtet sind, liegt der Ausfallswinkel β des überlagerten Laserstrahls 8 bei 0°, da für diesen Fall der Ausfallswinkel am zweiten Beugungs-Gitter 7 von der Wellenlänge der überlagerten Laserstrahlen 2a, ..., 2n unabhängig ist, wenn die Gitterkonstante $g_2$ und die Beugungsordnung $m_2$ des zweiten Beugungs-Gitters 7 geeignet gewählt werden. Wie sich anhand der weiter oben beschriebenen Gleichungen (1) und (2) ergibt, ist dies der Fall, wenn die Beugungs-Gitter 6, 7 die folgende Bedingung erfüllen: $m_2 / g_2 = m_1 / (2 g_1)$. Ist diese Bedingung erfüllt, kann eine im Wesentlichen dispersionsfreie Überlagerung der Laserstrahlen 2a, ..., 2n zu einem überlagerten Laserstrahl 8 erfolgen. Wie in Fig. 1 zu erkennen ist, sind die beugenden Strukturen des zweiten Beugungs-Gitters 7 an dessen dem ersten Beugungs-Gitter 6 zugewandten Seite angebracht. Durch die Anbringung der beugenden Strukturen an einander zugewandten Seiten der Beugungs-Gitter 6, 7 kann die Strahlqualität erhöht bzw. erhalten werden.

**Fig. 2** zeigt eine Vorrichtung 1, die sich von der in Fig. 1 gezeigten Vorrichtung dadurch unterscheidet, dass im Strahlweg zwischen dem ersten Beugungs-Gitter 6 und dem zweiten Beugungs-Gitter 7 ein Strahlteleskop angeordnet ist, das im vorliegenden Beispiel durch eine erste und zweite Linse 9, 10 gebildet ist, die im Abstand der Summe ihrer Brennweiten $f_{T1}$ + $f_{T2}$ zueinander angeordnet sind. Das erste Beugungs-Gitter 6 ist in einem Abstand zur ersten Linse 9 angeordnet, welcher im Wesentlichen deren Brennweite $f_{T1}$ entspricht, das zweite Beugungs-Gitter 7 ist in einem Abstand zur zweiten Linse 10 angeordnet, welcher deren Brennweite $f_{T2}$ entspricht. Für den Abbildungsmaßstab A (genauer |A|) des Strahlteleskops 9, 10 gilt in diesem Fall:

$$A = f_{T2} / f_{T1} .$$

Um in diesem Fall eine dispersionsfreie Überlagerung der Laserstrahlen 2a, ..., 2n zu einem überlagerten Laserstrahl 8 zu erhalten, muss die oben angegebene Beziehung zwischen den Eigenschaften der Beugungs-Gitter 6, 7 unter Berücksichtigung des Abbildungsmaßstabs A des Strahlteleskops 9, 10 modifiziert werden: Zur Realisierung eines wellenlängenunabhängigen Ausfallswinkels $\beta = 0°$ sollte in diesem Fall die Bedingung $A\, m_2 / g_2 = m_1 / (2\, g_1)$ erfüllt werden. Bei der in Fig. 2 gezeigten Anordnung wird der Strahlweg zwischen den Beugungs-Gittern 6, 7 vergrößert, was beispielsweise dazu genutzt werden kann, das zweite Beugungs-Gitter 7 in Reflexion zu betreiben bzw. vollständig reflektierend auszubilden. Der überlagerte Laserstrahl 8 muss in diesem Fall auf geeignete Weise vom Strahlengang der zu überlagernden Laserstrahlen 2a,..., 2n weggeführt werden.

Wie nachfolgend anhand von **Fig. 3** dargestellt wird, ist es auch möglich, die beiden Beugungs-Gitter 6, 7 als ein gemeinsames optisches Element auszubilden. In diesem Fall sind die Beugungs-Gitter 6, 7 an zwei gegenüber liegenden Oberflächen eines transmittierenden Grundkörpers 11 angebracht, wobei eine parallele Ausrichtung der Gitterebenen der beiden Beugungs-Gitter 6, 7 vorteilhaft ist. Da der transmittierende Grundkörper 11 einen Brechungsindex $n_2$ aufweist, der vom Brechungsindex des umgebenden Mediums $n_1 = 1{,}0$ abweicht, werden die Laserstrahlen 2a, ..., 2n beim Eintritt in den Grundkörper 11 gebrochen, so dass diese nicht mehr unter dem jeweiligen Littrow-Winkel $\alpha_{La}$, ..., $\alpha_{Ln}$ auf das zweite Beugungs-Gitter 7 auftreffen. Allerdings führt die Änderung der Wellenlänge im optisch dichteren Medium zu einer Modifikation der Gittergleichung (vgl. die Bedingung (2')). Für den Fall eines umgebenden Mediums mit $n_1 = 1{,}0$ führen die obigen Bedingungen (1) und (2') für die Eigenschaften der Beugungs-Gitter 6, 7 zur Erzeugung einer dispersionsfreien Überlagerung zu keiner Modifikation, so dass wie in Fig. 1 gilt: $m_2 / g_2 = m_1 / (2\, g_1)$. Der (gemeinsame) Ausfallswinkel $\beta$ liegt auch in diesem Fall typischer Weise bei $0°$.

An Stelle einer Überlagerungseinrichtung in Form des zweiten Beugungs-Gitters 7 kann auch ein anderes winkeldispersives optisches Element eingesetzt werden, beispielsweise ein Prisma, dessen Eigenschaften (Brechzahl bzw. Apex-Winkel) an die Eigenschaften des ersten Beugungs-Gitters 6 angepasst werden, um eine dispersionsfreie Überlagerung zu erreichen. Zur Erzeugung des Winkelspektrums auf dem ersten, teilweise reflektierenden Beugungs-Gitter 6 kann an Stelle eines abbildenden optischen Elements auch eine Strahlumlenkungseinrichtung dienen, wie weiter unten im Einzelnen erläutert wird.

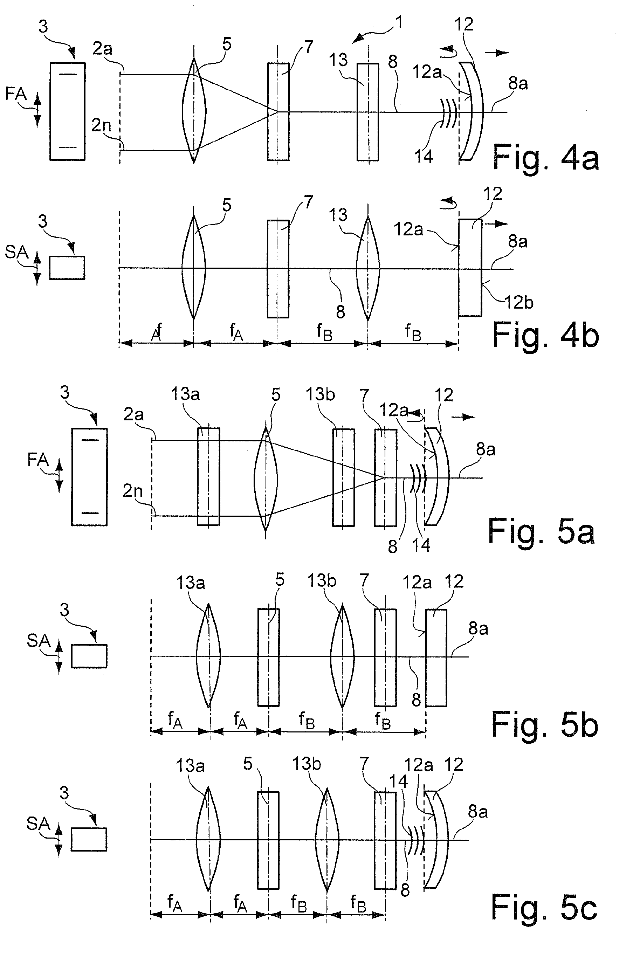

An Stelle einer Rückkopplungseinrichtung, die im Strahlengang der zu überlagernden Laserstrahlen 2a, ..., 2n angeordnet ist, ist es auch möglich, eine Rückkopplungseinrichtung zu verwenden, die im Strahlweg des überlagerten Laserstrahls 8 angeordnet ist, wie nachfolgend anhand einer in **Fig. 4a,b** gezeigten Vorrichtung 1 beschrieben wird. In Fig. 4a ist die Vorrichtung in der Ebene gezeigt, in der sich die Überlagerungsrichtung FA befindet, in Fig. 4b in einer zu dieser senkrechten Ebene entlang einer zweiten, zur ersten senkrechten Richtung SA. Die zu überlagernden Laserstrahlen 2a, ..., 2n werden von einer Laserquelle 3 erzeugt, von der in Fig. 4a eine Draufsicht auf die Stirnseite mit den Strahlaustrittsflächen gezeigt ist. Die Laserquelle 3 kann zur Erzeugung des in Fig. 4a gezeigten Strahlprofils auf unterschiedliche Weise ausgebildet sein, wie weiter unten näher beschrieben wird.

Die Laserstrahlen 2a, ..., 2n werden entlang der in Fig. 4a durch einen Doppelpfeil angedeuteten Überlagerungsrichtung FA überlagert, indem diese wie im Zusammenhang mit Fig. 1 erläutert mit Hilfe einer sphärischen Linse 5 auf ein als Überlagerungseinrichtung dienendes Beugungs-Gitter 7 abgebildet werden, wobei eine Ort-zu-Winkel-Transformation erfolgt. Abweichend von der in Zusammenhang mit Fig. 1 bis Fig. 3 beschriebenen Wellenlängenstabilisierung mit Hilfe einer im Strahlengang der zu überlagernden Laserstrahlen 2a, ..., 2n angeordneten Rückkopplungseinrichtung dient in Fig. 4a,b ein teilweise reflektierendes Auskoppelelement 12, welches im Strahlengang des überlagerten Laserstrahls 8 angeordnet ist, als Rückkopplungseinrichtung. Das teilweise reflektierende Auskoppelelement 12 weist zu diesem Zweck eine teilweise reflektierende Oberfläche 12a auf, die beispielsweise in Form einer auf einem transmittierenden Grundkörper aufgebrachten reflektierenden Beschichtung ausgebildet sein kann. Ein vom Auskoppelelement 12 transmittierter Strahlungsanteil verlässt als ausgekoppelter, überlagerter Laserstrahl 8a die Vorrichtung 1.

Wie in Fig. 4a erkennbar ist, weist der überlagerte Laserstrahl 8 eine im Wesentlichen sphärisch gekrümmte Wellenfront 14 auf. Die Reflexion des zur Laserquelle 3 zurückgekoppelten Strahlungsanteils des überlagerten Laserstrahls 8 an einem Auskoppelelement mit einer planen, teilweise reflektierenden Oberfläche würde aufgrund der nicht planen Wellenfront 14 dazu führen, dass der zur Laserquelle 3 zurück reflektierte Strahlungsanteil einen jeweiligen Laser-Emitter nicht präzise genug trifft, wodurch sich die Wellenlängenstabilisierung verschlechtert und die spektrale Bandbreite der emittierten Laserstrahlen 2a,..., 2n erhöht. Zur Verbesserung der Einkopplung des zur Laserquelle 3 zurück reflektierten Strahlungsanteils in die (in Fig. 4a,b nicht gezeigten) Laser-Emitter ist die teilweise reflektierende Oberfläche 12a zylindrisch (konkav) gekrümmt, wobei der Krümmungsradius der Oberfläche 12a an den Krümmungsradius der Wellenfront 14 angepasst ist, d.h. im Wesentlichen mit diesem übereinstimmt. Auf diese Weise kann erreicht werden, dass der zurück reflektierte Strahlungsanteil des überlagerten Laserstrahls 8 mit hoher Präzision in die Laser-Emitter eingekoppelt werden kann und sich die Effizienz der Rückkopplung deutlich erhöht.

Zwischen dem Beugungs-Gitter 7 und dem Auskoppelelement 12 ist eine weitere Zylinderlinse 13 (mit Brennweite $f_B$) angeordnet, welche gemeinsam mit der die Ort-zu-Winkel-Transformation erzeugenden sphärischen Linse 5 ein Strahlteleskop bildet. Das Strahlteleskop 5, 13 dient zur Realisierung einer 4f-Abbildung zwischen einer Brennebene der sphärischen Linse 5, in welcher sich die Lichtaustrittsflächen der (nicht gezeigten) Laser-Emitter befinden und einer Ebene, in welcher die teilweise reflektierende Oberfläche 12a angeordnet ist. Durch die 4f-Abbildung mittels des Strahlteleskops 5, 13 kann die Effizienz der Rückkopplung in SA-Richtung erhöht werden.

Das Auskoppelelement 12 ist bei dem in Fig. 4a,b gezeigten Beispiel als Meniskus-Linse ausgebildet und weist an der Auskoppelseite eine konvex gekrümmte Oberfläche 12b auf, welche zur Strahlformung des ausgekoppelten überlagerten Laserstrahls 8a dient. Im vorliegenden Beispiel ist die Krümmung an der Auskoppelseite so gewählt, dass der ausgekoppelte überlagerte Laserstrahl 8a kollimiert aus der Vorrichtung 1 austritt. Es versteht sich, dass die Strahlformung des ausgekoppelten überlagerten Laserstrahls 8a auch auf andere Weise als durch das Vorsehen einer gekrümmten Oberfläche 12b erfolgen kann.

Die in Fig. 5a,b gezeigte Vorrichtung 1 unterscheidet sich von der Vorrichtung 1 von Fig. 4a,b dadurch, dass an Stelle einer sphärischen Linse eine Zylinderlinse 5 für die Realisierung der Ort-zu-Winkel-Transformation in FA-Richtung verwendet wird sowie dadurch, dass das Strahlteleskop in SA-Richtung mit zwei Zylinderlinsen 13a, 13b realisiert ist, die im Strahlengang vor dem als Überlagerungseinrichtung dienenden Beugungs-Gitter 7 angeordnet sind. Durch in Fig. 5a,b gezeigte Art der Realisierung der Vorrichtung 1 kann der Abstand zwischen dem Beugungs-Gitter 7 und dem Auskoppelelement 12 gegenüber dem in Fig. 4a,b gezeigten Ausführungsbeispiel reduziert werden, was sich günstig auf die Strahlqualität auswirkt.

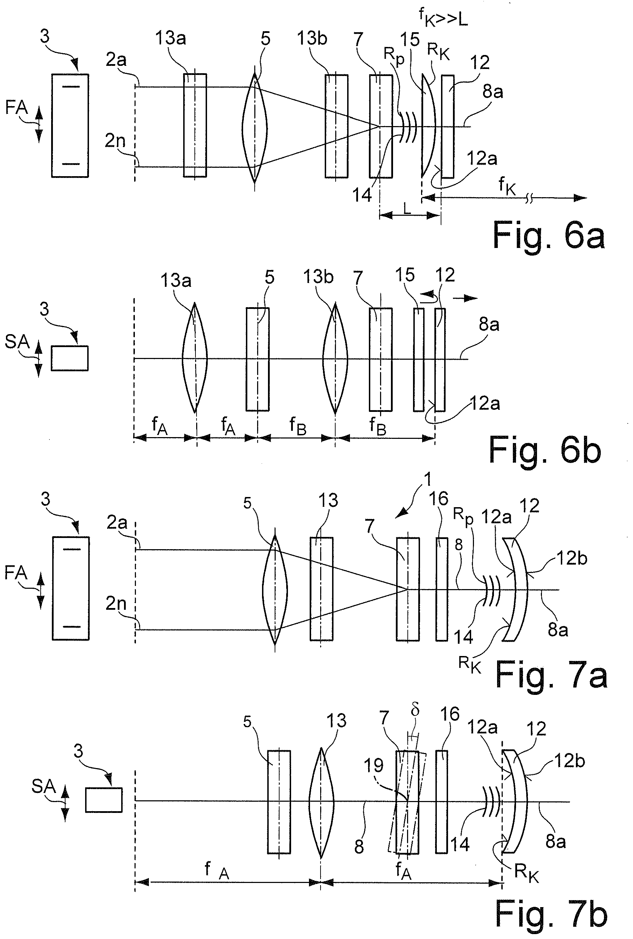

Mit dem Strahlteleskop ist es durch Anpassung der Brennweiten der Zylinderlinsen 13a, 13b möglich, die Abbildung der Laserstrahlen an einen beliebigen Ort in der Vorrichtung 1 zu legen. Eine weiteres besonders vorteilhaftes Ausführungsbeispiel, bei dem diese Möglichkeit ausgenutzt wird, ist in Fig. 5c dargestellt, wobei hier nur die SA-Richtung gezeigt ist (FA-Richtung z.B. wie in Fig. 5a). Das SA-Teleskop kann derart ausgelegt werden bzw. die Brennweiten $f_A$, $f_B$ der Zylinderlinsen 13a, 13b können so gewählt werden, dass die Abbildung am Ort des Beugungsgitters 7 entsteht und die resultierende Krümmung der Phasenfront in SA-Richtung mit einem in SA-Richtung gekrümmten Auskoppelelement 12, genauer gesagt mittels einer geeignet gekrümmten reflektierenden Oberfläche 12a kompensiert werden kann. Besonders vorteilhaft ist es, die Brennweiten $f_A$, $f_B$ der Zylinderlinsen 13a, 13b so zu wählen, dass wie weiter unten im Zusammenhang mit Fig. 7a,b beschrieben das Auskoppelelement 12 rein sphärisch ausgebildet werden kann. Es versteht sich, dass anders als in Fig. 5b und Fig. 5c gezeigt die zwischen den beiden Zylinderlinsen 13a, 13b gebildete Brennebene nicht an der Position der Fokussierlinse 5 liegen muss, sonder auch zu dieser Position versetzt angeordnet sein kann.

Die in Fig. 6a,b gezeigte Vorrichtung 1 unterscheidet sich von der in Fig. 5a,b gezeigten Vorrichtung 1 im Wesentlichen dadurch, dass die teilweise reflektierende Oberfläche 12a des Auskoppelelements 12 plan ausgebildet ist. Als Phasenkorrekturelement dient in diesem Fall eine Zylinderlinse 15, beispielsweise in Form einer Plankonvexlinse, welche den überlagerten Laserstahl 8 kollimiert, bevor dieser auf die plane Oberfläche 12a des Auskoppelelements 12 auftrifft. Die Linsenkrümmung bzw. der Krümmungsradius $R_K$ der als Phasenkorrekturelement dienenden Zylinderlinse 15 ist an den Krümmungsradius Rp der Wellenfront 14 angepasst, d.h. die beiden Radien stimmen (annähernd) überein. Aufgrund des vergleichsweise großen Krümmungsradius Rp der Wellenfront 14, der in der Regel bei mehr als zwei Metern liegt, liegt auch die Brennweite $f_K$ der Zylinderlinse 15 bei mehr als ca. zwei Metern (in Fig. 6b lediglich angedeutet) und ist damit wesentlich größer als der Abstand L zwischen dem als Überlagerungseinrichtung dienenden Beugungs-Gitter 7 und dem Auskoppelelement 12, welcher typischer Weise zwischen ca. 2 cm und ca. 20 cm liegt.

In Fig. 7a,b ist eine Vorrichtung 1 gezeigt, welche sich von der in Fig. 4a,b gezeigten Vorrichtung 1 u.a. dadurch unterscheidet, dass das Auskoppelelement 12 eine teilweise reflektierende sphärisch gekrümmte konkave Oberfläche 12a sowie eine entsprechende sphärisch gekrümmte konvexe Oberfläche 12b an der Auskoppelseite aufweist. Um eine Phasenkorrektur und damit eine Optimierung der Rückkopplung sowohl in der in Fig. 7a gezeigten Überlagerungsrichtung FA als auch in einer dazu senkrechten Richtung zu erreichen, ist es typischer Weise erforderlich, die Brechkräfte der beteiligten Phasenkorrekturelemente in beiden Richtungen unterschiedlich zu wählen, da sich typischer Weise die Krümmung der Wellenfront 14 in den beiden Richtungen unterscheidet.

Bei dem in Fig. 7a,b gezeigten Beispiel wird die Phasenkorrektur bzw. der Krümmungsradius $R_K$ der sphärisch gekrümmten teilweise reflektierenden Oberfläche 12a derart gewählt, dass dieser mit dem Krümmungsradius $R_P$ der Wellenfront 14 in Richtung der Überlagerungsrichtung FA übereinstimmt (vgl. Fig. 7a). Weicht der Krümmungsradius der Wellenfront 14 in der Überlagerungsrichtung FA von demjenigen in der Richtung senkrecht dazu ab, kann mittels einer Zylinderlinse 13 eine Abbildung der Ebene mit der teilweise reflektierenden Oberfläche 12a auf die Ebene mit den Strahlaustrittsflächen der (nicht gezeigten) Laser-Emitter erfolgen, um auch in der Richtung SA senkrecht zur Überlagerungsrichtung FA die Rückkopplung zu optimieren und somit Rückkopplungsverluste in beiden Richtungen bzw. Dimensionen zu minimieren. Zur Optimierung der Rückkopplung sowohl in FA-Richtung als auch in SA-Richtung ist in der Regel die Verwendung von optischen Korrekturelementen mit unterschiedlichen Brechkräften in FA-Richtung und in SA-Richtung erforderlich.

Zusätzlich zu der als Phasenkorrektureinrichtung dienenden teilweise reflektierenden sphärisch gekrümmten optischen Oberfläche 12a ist im Strahlengang des überlagerten Laserstrahls 8 ein Polarisationsfilter 16 angeordnet, welcher unerwünschte Polarisationsanteile, insbesondere von unerwünschten TM-Moden ausfiltert, die von den (nicht gezeigten) Laser-Emittern der Laserquelle 3 erzeugt werden, so dass diese nicht zur Laserquelle 3 zurück reflektiert und in die dort vorgesehenen Laser-Emitter eingekoppelt werden. Hierbei wird ausgenützt, dass die von einem jeweiligen Laser-Emitter emittierte Laserstrahlung einen Strahlungsanteil (bzw. Intensitätsanteil) von typischer Weise mehr als ca. 95 % mit einer linearen Polarisation in einer Haupt-Polarisationsrichtung aufweist und nur ein Strahlungsanteil von ca. 5 % nicht entlang der Haupt-Polarisationsrichtung polarisiert ist. Der Anteil der Laserstrahlung, der in Richtung der Haupt-Polarisationsrichtung polarisiert ist, weist gegenüber dem nicht entlang der Haupt-Polarisationsrichtung polarisierten Strahlungsanteil eine höhere Strahlqualität auf, so dass durch das Vorsehen des Polarisationsfilters 16, welcher die nicht in Richtung der Haupt-Polarisationsrichtung polarisierten Strahlungsanteile ausfiltert, die Strahlqualität bzw. die Rückkoppeleffizienz des zur Laserquelle 3 zurück reflektierten Strahlungsanteils erhöht werden kann.

Bei dem in Fig. 7a,b gezeigten Beispiel ist der Polarisationsfilter 16 im Strahlweg des überlagerten Laserstrahls 8 zwischen der Überlagerungseinrichtung 7 und dem Auskoppelelement 12 angeordnet. Der überlagerte Laserstrahl 8 ist im Wesentlichen kollimiert, was sich günstig auf die Polarisationsfilterung auswirkt. Es versteht sich, dass der Polarisationsfilter 16 auch bei den weiter oben in Zusammenhang mit Fig. 1 bis Fig. 6a,b beschriebenen Vorrichtungen 1 vorteilhaft eingesetzt werden kann. Es versteht sich, dass der Polarisationsfilter 16 im Strahlweg zwischen der Laserquelle 3 und der Rückkopplungseinrichtung angeordnet werden muss, so dass der Polarisationsfilter 16 bei den in Fig. 1 bis Fig. 3 gezeigten Vorrichtungen 1 im Strahlweg der zu überlagernden Laserstrahlen 2a, ..., 2n angeordnet werden muss. Auch bei den in Fig. 4a,b bis Fig. 7a,b gezeigten Vorrichtungen 1 kann der Polarisationsfilter 16 im Strahlweg der zu überlagernden Laserstrahlen 2a, ..., 2n angeordnet werden.

Alternativ zu den im Zusammenhang mit Fig. 4a,b bis Fig. 7a,b beschriebenen Vorrichtungen 1 kann das Auskoppelelement 12 eine teilweise reflektierende Oberfläche aufweisen, die in zwei Richtungen eine unterschiedliche Krümmung aufweist, d.h. in der Art eines Kreuzzylinders ausgebildet ist. Insbesondere kann bei den in Zusammenhang mit Fig. 4a,b und Fig. 5a,b beschriebenen Vorrichtungen 1 an Stelle eines Auskoppelelements 12 mit einer teilweise reflektierenden zylindrisch gekrümmten Oberfläche 12a ein Auskoppelelement 12 mit einer z.B. sphärisch gekrümmten oder ggf. asphärischen Krümmung verwendet werden.

Bei den gezeigten Beispielen kann auch eine Phasenkorrektureinrichtung in Form einer (nicht gezeigten) Phasenkorrekturplatte verwendet werden, um an jedem Ort des Strahlquerschnitts des überlagerten Laserstrahls 8 die Phasenkorrektur, genauer gesagt die Abweichung zu der durch die gekrümmte teilreflektierende Oberfläche 12a bzw. durch die kollimierende Linse 15 erzeugte Phasenkorrektur individuell einzustellen. Es versteht sich, dass die Phasenkorrektur gegebenenfalls auch ausschließlich durch eine im Strahlweg des überlagerten Laserstrahls 8 angeordnete Phasenkorrekturplatte erfolgen kann.

Auch ist es bei den gezeigten Beispielen in Fig. 4 bis Fig. 7, bei denen die Rückkopplung im Strahlweg hinter der Überlagerungseinrichtung 7 erfolgt, auf erstaunlich einfache Weise möglich, die zu stabilisierenden Wellenlängen der Laserstrahlen 2a, ..., 2n der Laserquelle 3 durchzustimmen. Hierfür wird das Beugungsgitter 7 wie beispielhaft in Fig. 7b gezeigt ist um eine Drehachse 19 senkrecht zur Zeichenebene unter einem Drehwinkel $\delta$ gedreht, wodurch sich der bzw. die Einfallswinkel der Laserstrahlen 2a, ..., 2n auf das Beugungsgitter 7 und damit auch die von der Vorrichtung 1 stabilisierten Wellenlängen der Laserstrahlen 2a, ..., 2n verändern.

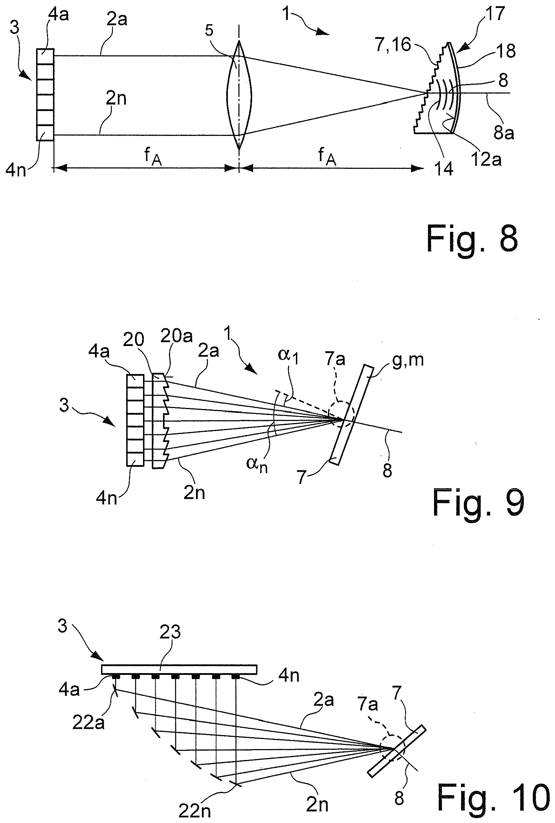

Fig. 8 zeigt ein Ausführungsbeispiel einer Vorrichtung 1, welche sich von den weiter oben beschriebenen Vorrichtungen dadurch unterscheidet, dass die Überlagerungseinrichtung in Form eines Beugungs-Gitters 7 und die Rückkopplungseinrichtung in Form der teilreflektierenden Oberfläche als ein gemeinsames optisches Element 17 ausgebildet sind. Das gemeinsame optische Element 17 weist einen für die Laserstrahlung transmissiven Grundkörper auf, an dessen einer Stirnseite das Beugungs-Gitter 7 zur Überlagerung angebracht ist und an dessen zweiter, gegenüber liegender Stirnseite 12a eine teilweise reflektierende Beschichtung 18 aufgebracht ist, um einen Strahlungsanteil des überlagerten Laserstrahls 8 zurück zur Lichtquelle 3 zu reflektieren. Die Stirnseite 12a des im Wesentlichen prismenförmigen optischen Elements 17 mit der teilweise reflektierenden Beschichtung 18 weist eine Krümmung auf, die an die Krümmung der Wellenfront 14 angepasst ist, so dass das optische Element 17 auch als Phasenkorrekturelement dient.

Bei der in Fig. 7 gezeigten Ausführungsform ist das Beugungs-Gitter 7 als Polarisationsfilter 16 ausgelegt, da das Beugungs-Gitter 7 mit einer polarisationsselektiven Beschichtung versehen ist. Entsprechend kann auch bei den weiter oben beschriebenen Ausführungsbeispielen die Überlagerungseinrichtung 7 bzw. die Rückkopplungseinrichtung 6, 12 als Polarisationsfilter ausgelegt werden. Es versteht sich, dass die Kombination von Polarisationsfilter und Rückkopplungs- bzw. Überlagerungseinrichtung auch auf andere Weise als durch eine dielektrische Beschichtung erfolgen kann.

Alternativ zur in Fig. 1 gezeigten Ort-zu-Winkel Transformation zur Erzeugung eines Winkel-Spektrums auf der winkeldispersiven Überlagerungseinrichtung 7 ist es auch möglich, eine Strahlumlenkungseinrichtung zu verwenden, welche die zu überlagernden Laserstrahlen 2a, ..., 2n in unterschiedlichen Winkeln $\alpha_1$ bis $\alpha_n$ auf einen gemeinsamen Überlappungsbereich 7a der Überlagerungseinrichtung 7 ausrichtet. Dies kann, wie in **Fig. 9** dargestellt ist, mittels eines transmissiven Facettenelements 20 erfolgen, welches eine Mehrzahl von keilförmigen Facetten 20a aufweist. Jedem zu überlagernden Laserstrahl ist hierbei eine Facette 20a zugeordnet, die derart ausgebildet ist, dass der jeweils auftreffende zu überlagernde Laserstrahl 2a, ..., 2n so gebrochen wird, dass dieser unter dem gewünschten Winkel $\alpha_1$, ..., $\alpha_n$ auf dem (annähernd) punktförmigen Überlappungsbereich 7a der als Beugungs-Gitter 7 (mit Gitterkonstante g bzw.

mit Beugungsordnung m) ausgebildeten Überlagerungseinrichtung auftrifft. Es versteht sich, dass bei den in Zusammenhang mit Fig. 1 bis Fig. 3 beschriebenen Vorrichtungen 1 der Überlappungsbereich 7a auch an dem als Rückkopplungseinrichtung dienenden ersten Beugungs-Gitter 6 gebildet werden kann. Das Facettenelement 20 bietet den Vorteil, dass die Vorrichtung 1 kompakter als mit einer Transformationslinse aufgebaut werden kann, da der Abstand zwischen der Lichtquelle 3 und dem Facettenelement 20 sehr klein gewählt werden kann. Anders als in Fig. 7 gezeigt ist, kann das Facettenelement 20 sich unmittelbar an die Lichtquelle 3 anschließen. Bei Vorrichtungen mit Strahlumlenkungseinrichtungen wie z.B. dem in Fig. 9 gezeigten Facettenelement 20 ist es besonders sinnvoll, eine Phasenkorrektur des überlagerten Laserstrahls 8 vorzusehen, wie in den Figuren 4 bis 8 gezeigt ist.

Das in Fig. 9 gezeigte Facettenelement 20 kann mit einem weiteren (nicht gezeigten) Facettenelement kombiniert werden, wobei jeweils zwei Facetten der beiden Facettenelemente in der Art eines anamorphotischen Prismenpaars zusammenwirken, um den Füllfaktor bei der Ausrichtung der zu überlagernden Laserstrahlen 2a, ..., 2n an dem Überlappungsbereich 7a der als Beugungs-Gitter 7 ausgebildeten Überlagerungseinrichtung zu erhöhen. Die Erhöhung des Füllfaktors mittels einer solchen Prismenanordnung wird weiter unten näher beschrieben.

**Fig. 10** zeigt ein Detail einer Vorrichtung 1, die ebenfalls eine Strahlformungseinrichtung aufweist, die eine der Anzahl der zu überlagernden Laserstrahlen 2a, ..., 2n entsprechende Anzahl von Umlenkspiegeln 22a, ..., 22n aufweist. Die zu überlagernden Laserstrahlen 2a, ..., 2n werden in diesem Beispiel von einer Laserquelle 3 erzeugt, die eine Mehrzahl von Laserbarren 4a, ..., 4n aufweist, die in Form eines vertikalen Stapels angeordnet sind und die an der Rückseite über eine gemeinsame, als Träger dienende DCB-Wärmesenke 23 gekühlt werden, so dass ein hoher Füllfaktor, d.h. ein geringer Abstand, zwischen den Laserbarren 4a, ..., 4n realisiert werden kann. Es versteht sich, dass die Laserbarren 4a, ..., 4n anders als in Fig. 10 dargestellt nicht in einem konstanten, sondern auch in einem unterschiedlichen Abstand zueinander angeordnet sein können.

Die planen Umlenkspiegel 22a, ..., 22n sind so positioniert und unter einem solchen Winkel zu den Laserbarren 4a, ..., 4n ausgerichtet, dass diese an dem gemeinsamen Überlappungsbereich 7a auf der Überlagerungseinrichtung 7 auftreffen. Um die Effektivität der Rückkopplung in die Laserbarren 4a, ..., 4n zu erhöhen, kann es vorteilhaft sein, wenn die Weglängen zwischen den Laserbarren 4a, ..., 4n und dem Überlappungsbereich 7a gleich groß sind. Aufgrund der vorhandenen Freiheitsgrade sowohl bezüglich der Positionierung als auch bezüglich der Umlenkwinkel der Umlenkspiegel kann die Bedingung gleicher Weglängen in der Regel erfüllt werden. In Abhängigkeit von der Qualität der Kollimation der zu überlagernden Laserstrahlen 2a, ..., 2n kann ggf. auf die Forderung nach gleichen Weglängen verzichtet werden.

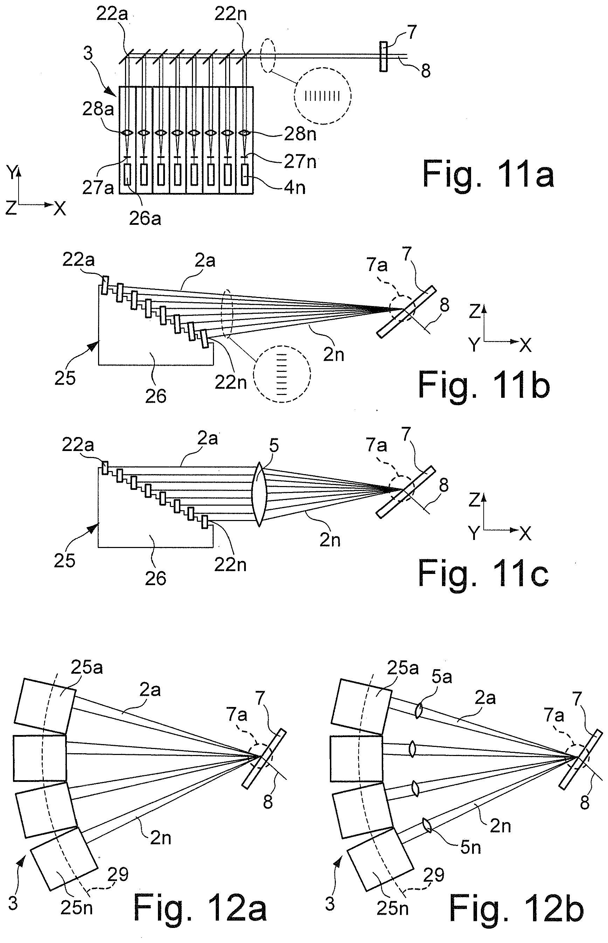

Eine Überlagerung mit Hilfe einer Strahlformungseinrichtung, welche eine Mehrzahl von Umlenkspiegeln zur 22a, ..., 22n zur Ausrichtung von zu überlagernden Laserstrahlen 2a, ..., 2n auf einen gemeinsamen Überlappungsbereich 7a einer Überlagerungseinrichtung 7 aufweist, ist auch in **Fig. 11a,b** dargestellt. Bei der in Fig. 11a,b gezeigten Anordnung dient als Laserquelle 3 ein optisches Modul 25, welches eine Mehrzahl (im vorliegenden Beispiel acht) Einzel-Emitter 4a, ..., 4n aufweist, die auf unterschiedlichen Stufen einer gemeinsamen Wärmesenke 26 angeordnet sind.

Jedem Einzel-Emitter 4a, ..., 4n ist eine erste Kollimationslinse 27a,..., 27n zugeordnet, welche der Kollimation der Laserstrahlen 2a, ..., 2n in FA-Richtung dient (entsprechend der Z-Richtung eines XYZ-Koordinatensystems). Eine zweite Kollimationslinse 28a, ..., 28n dient der Kollimation eines jeweiligen Laserstrahls 2a, ... , 2n in einer zweiten, zur ersten senkrechten Richtung (SA-Richtung), welche der X-Richtung der in Fig. 11a,b gezeigten Anordnung entspricht. Um die Überlagerung der kollimierten Laserstrahlen 2a, ..., 2n auf dem gemeinsamen Überlappungsbereich 7a der Überlagerungseinrichtung 7 zu ermöglichen, sind die Umlenkspiegel 22a, ..., 22n, genauer gesagt deren Spiegelebenen, gegenüber der XY-Ebene geneigt bzw. verkippt, wie in Fig. 11b angedeutet ist.

Das von dem optischen Modul 25 erzeugte Strahlprofil ist in Fig. 11a und in Fig. 11b jeweils in der YZ-Ebene gezeigt. Das Strahlaustrittsprofil, das von dem optischen Modul 25 erzeugt wird, weist mehrere (im vorliegenden Beispiel acht) in einer Dimension bzw. Richtung übereinander angeordnete Laserstrahlen 2a, ..., 2n auf. Die Dimension, in welcher die Stapelung bzw. die Anordnung der Laserstrahlen 2a, ..., 2n erfolgt, ist im vorliegenden Fall die Z-Richtung, welche der FA-Richtung der Laser-Emitter 4a, ..., 4n entspricht.

Wie in **Fig. 11c** gezeigt ist, können die Umlenkspiegel 22a, ..., 22n im optischen Modul 25 auch parallel ausgerichtet sein, so dass die umgelenkten Laserstrahlen 2a ... 2n parallel zueinander verlaufen. Um die Überlagerung der kollimierten Laserstrahlen 2a, ..., 2n auf dem gemeinsamen Überlappungsbereich 7a der Überlagerungseinrichtung 7 zu ermöglichen, wird in diesem Beispiel eine Transformationslinse 5 verwendet.

Während bei der in Fig. 11a,b gezeigten Anordnung die Laserstrahlen 2a, ..., 2n mehrerer Einzel-Emitter 4a, ..., 4n überlagert werden, wird bei der in **Fig. 12a** gezeigten Anordnung eine Überlagerung von Laserstrahlen 2a, ..., 2n vorgenommen, die von einer Laserquelle 3 mit mehreren (im gezeigten Beispiel vier) optischen Modulen 25a, ..., 25n erzeugt werden, die wie in Fig. 11a,b dargestellt ausgebildet sind. Die optischen Module 25a,..., 25n sind zur Überlagerung auf dem Überlappungsbereich 7a der Überlagerungseinrichtung 7 auf einem gemeinsamen Kreisbogen 29 angeordnet und auf den Überlappungsbereich 7a ausgerichtet, der sich ungefähr am Mittelpunkt des Kreisbogens 29 befindet.

**Fig. 12b** zeigt eine Anordnung, bei der die optischen Module 25a, ...,25n jeweils einen kollimierten Laserstrahl 2a, ..., 2n (bzw. ein kollimiertes Laserstrahlenbündel) abstrahlen (vgl. Fig. 11c). Um die Überlagerung der kollimierten Laserstrahlen 2a, ..., 2n auf dem gemeinsamen Überlappungsbereich 7a der Überlagerungseinrichtung 7 zu ermöglichen, ist jeweils eine Transformationslinse 5a ..., 5n nach jedem optischen Modul 25a, ..., 25n angeordnet.

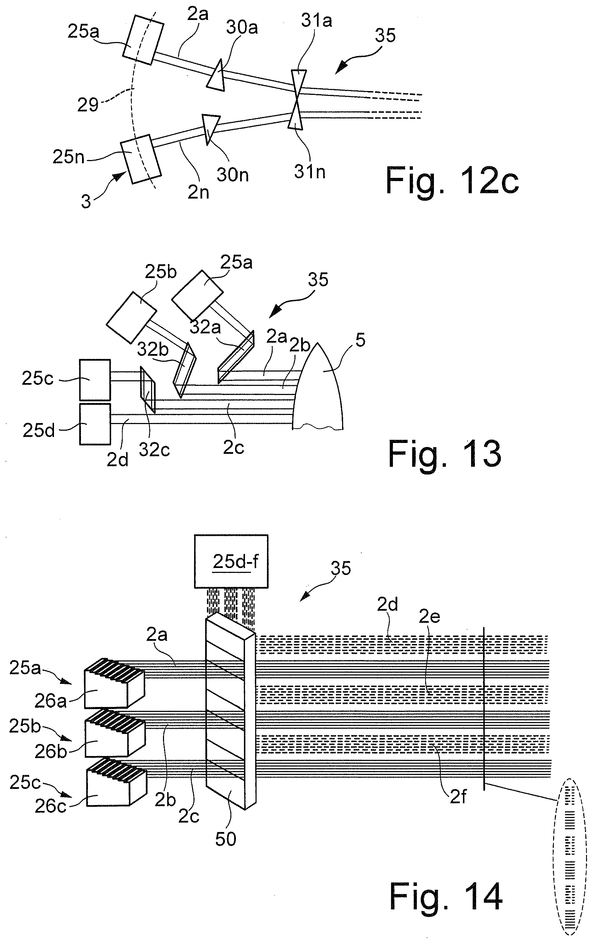

**Fig. 12c** zeigt eine Anordnung analog Fig. 12a, bei welcher zwischen den optischen Modulen 26a, ..., 25n und der (in Fig. 12b nicht gezeigten) Überlagerungseinrichtung eine optische Einrichtung 35 mit mehreren (im vorliegenden Beispiel vier) keilförmigen Umlenkprismen 30a, 30n, 31a, ..., 31n vorgesehen ist, welche die auf den gemeinsamen Mittelpunkt ausgerichteten Laserstrahlen 2a, ..., 2n umlenken, wodurch sich der Abstand zwischen den auf der Überlagerungseinrichtung auftreffenden umgelenkten Laserstrahlen 2a, ..., 2n verringert und damit der Füllfaktor der gezeigten Anordnung erhöht. Die beiden einem jeweiligen Laserstrahl 2a, ..., 2n zugeordneten Prismen 30a, 31a, ..., 30n, 31n wirken hierbei jeweils in der Art eines anamorphotischen Prismenpaars zusammen.

Die in Fig.12c gezeigte Anordnung, genauer gesagt die optische Einrichtung 35, kann auch als vollständig reflektive Einrichtung ausgestaltet werden. Hierfür können die Prismen 30a, 31a,..., 30n, 31n durch einen facettierten Spiegel oder durch nahe beieinanderliegende Einzelspiegel ersetzt. Dies ist vorteilhaft, da die für die Spiegel verwendeten Substrate preisgünstiger sind als die Substrate der Prismen 30a, 31, ..., 30n, 31n.

**Fig. 13** zeigt vier Laserstrahlen 2a bis 2d, welche von vier optischen Modulen 25a bis 25d erzeugt werden und welche mit Hilfe einer optischen Einrichtung 35 in Form von drei trapezförmigen Umlenkprismen 32a bis 32c parallel ausgerichtet werden, um den Füllfaktor zu erhöhen. Die vier parallel ausgerichteten Laserstrahlen 2a, ..., 2d treffen auf eine Fokussierlinse 5, welche zur Fokussierung der Laserstrahlen 2a bis 2d gemeinsam mit vier weiteren (nicht gezeigten) Laserstrahlen, die von entsprechenden (nicht gezeigten) optischen Modulen erzeugt werden, auf einem (nicht gezeigten) Überlagerungsbereich dient. Die in Fig. 13 gezeigte optische Einrichtung 35 kann auch wie im Zusammenhang mit Fig. 12c dargestellt mit reflektiven optischen Komponenten realisiert werden. Beispielsweise kann ein jeweiliges Umlenkprisma 32a bis 32c durch zwei Umlenkspiegel ersetzt werden.

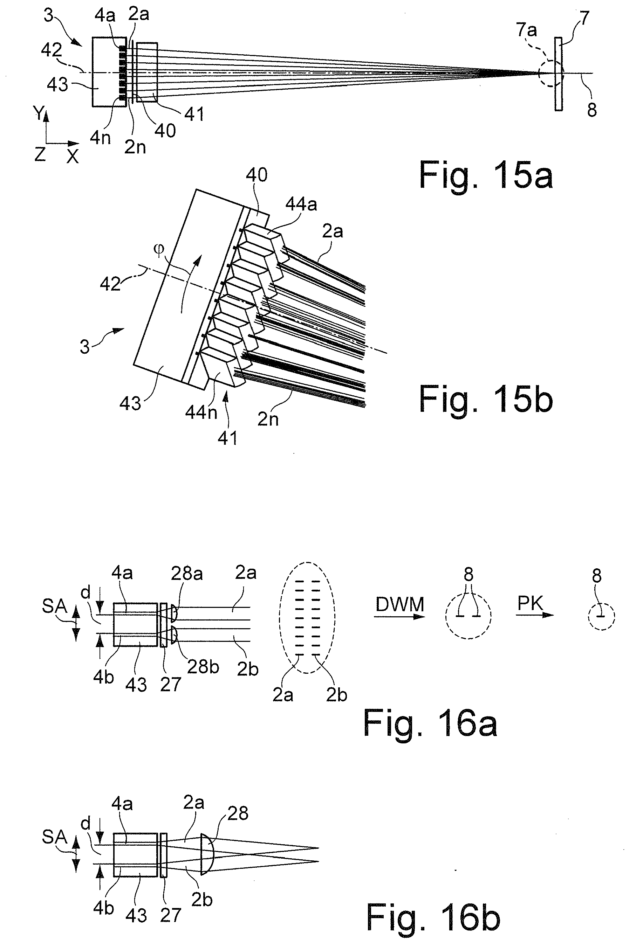

**Fig. 14** zeigt eine optische Einrichtung 35, die eine Verkämmungseinrichtung in Form eines Schlitzspiegels 30 aufweist, um eine Mehrzahl von Laserstrahlen, genauer gesagt von Laserstrahlenbündeln 2a, 2b, 2c, die an drei übereinander gestapelten Wärmesenken 26a-c dreier optischer Module 25a-c erzeugt werden, mit drei gestrichelt dargestellten Laserstrahlenbündeln 2d, 2e, 2f zu verkämmen, die von drei weiteren optischen Modulen 25d-f erzeugt werden. Die Anordnung der drei weiteren Module 25d-f (Stapelung) entspricht derjenigen der ersten drei optischen Module 25a-c. Die drei weiteren optischen Module 25d-f sind so angeordnet, dass die von diesen erzeugten Laserstrahlen 2d, 2e, 2f zunächst senkrecht zu den Laserstrahlen 2a, 2b, 2c der ersten drei optischen Module 25a-c verlaufen und an Spiegelflächen umgelenkt werden, die auf der Rückseite des Schlitzspiegels 30 angebracht sind, so dass diese nach der Umlenkung parallel zu den Laserstrahlen 2a, 2b, 2c ausgerichtet sind. Die Stapelung der optischen Module 25a, 25b, 25c kann durch einen (nicht gezeigten) Träger erfolgen, an dem die Wärmesenken 26a-c befestigt sind. Anders als in Fig. 15 dargestellt ist, können die treppenförmigen Wärmesenken 26a-c auch direkt aneinander angrenzend angeordnet sein, d.h. die Unterseite der zweiten Wärmesenke 26b ist an der obersten Stufe der ersten Wärmesenke 26a angebracht. Entsprechend kann auf die oberste Stufe der zweiten Wärmesenke 26b die dritte Wärmesenke 26c aufgesetzt sein, um einen vertikalen Stapel zu bilden.

Für die Verkämmung der Laserstrahlen 2a-f, die von zwei vertikalen Stapeln von optischen Modulen 25a-c, 25d-f erzeugt werden, ist es günstig, wenn die von einem jeweiligen Stapel 25a-c, 25d-f erzeugten Laserstrahlen bzw. Laserstrahlen-Bündel 2a-c, 2d-f jeweils einen Füllfaktor von annähernd 50 % aufweisen, so dass die Verkämmung auf eine solche Weise erfolgen kann, dass die Lücken, die von den Laserstrahlen 2a-c des einen Stapels von optischen Modulen 25a-c erzeugt werden, von den Laserstrahlen 2d-f des anderen Stapels von optischen Modulen 25d-f gefüllt werden, wie anhand des in Fig. 15 gezeigten Strahlprofils zu erkennen ist.

**Fig. 13a,b** zeigen eine weitere Möglichkeit, um eine Mehrzahl (hier: acht) Laserstrahlen 2a, ..., 2n auf einen gemeinsamen Überlappungsbereich 7a auszurichten, welcher an einer Überlagerungseinrichtung 7 in Form eines Beugungs-Gitters gebildet ist. Die Laserstrahlen 2a, ..., 2n werden von Laser-Emittern 4a, ..., 4n erzeugt, die in einer gemeinsamen Ebene X, Y nebeneinander auf einem Laserbarren 43 angeordnet sind. Die parallel zueinander aus den Laser-Emittern 4a, ..., 4n austretenden Laserstrahlen 2a, ..., 2n treffen zunächst auf eine Kollimationslinse 40, welche im gezeigten Beispiel zur Kollimation der Laserstrahlen 2a, ..., 2n in einer Richtung Z senkrecht zu der gemeinsamen Ebene X, Y ausgebildet ist, welche bei der gezeigten Anordnung der FA-Richtung entspricht. Die Kollimationslinse 40 ist als Zylinderlinse ausgebildet und erstreckt sich in Y-Richtung entlang der gesamten Breite des Laserbarrens 43.

Im Strahlweg auf die Kollimationslinse 40 folgend ist eine Transformationseinrichtung 41 angeordnet, welche zur Drehung der Orientierung der Laserstrahlen 2a, ..., 2n (als optischer Rotator) dient und welche wie in der eingangs zitierten US 2011/0216417 A1 beschrieben ausgebildet sein kann. Bei dem in Fig. 13a,b gezeigten Beispiel wird ein Array von Zylinderlinsen 44a, ..., 44n als optischer Rotator verwendet, welche eine Drehung der Ausrichtung der Laserstrahlen 2a, ..., 2n um 90° bewirken.

Um die Überlagerung der Laserstrahlen 2a, ..., 2n mit Hilfe der in Fig. 13a,b gezeigten Anordnung zu bewirken, ist die Kollimationslinse 40 in Bezug auf die XY-Ebene um einen Winkel $\varphi$ (vgl. Fig. 13b) verdreht, und zwar um eine Drehachse 42, welche in der Verlängerung des überlagerten Laserstrahls 8 zentral durch den Laserbarren 43 verläuft. Der Winkel $\varphi$, unter dem die Kollimationslinse 40 zur XY-Ebene verdreht wird, um die Überlagerung zu bewirken, ist gering und liegt im vorliegenden Beispiel bei ca. 0,5°. Aufgrund des geringen Drehwinkels φ ist die Kollimationslinse 40 in Fig. 13b wie eine herkömmliche Kollimationslinse dargestellt, d.h. mit einer Ausrichtung parallel zur XY-Ebene, in welcher die Laser-Emitter 4a,..., 4n angeordnet sind.

Die Drehung der Kollimationslinse 40 erzeugt einen jeweils unterschiedlichen Winkel beim Eintritt der Laserstrahlen 2a,..., 2n in die Transformationseinrichtung 41. Die unterschiedlichen Winkel beim Eintritt in die Transformationseinrichtung 41 führen dazu, dass die Laserstrahlen 2a, ..., 2n beim Austritt aus der Transformationseinrichtung 41 konvergent verlaufen, so dass diese in einem gewünschten, durch den Betrag des Drehwinkels φ veränderbaren Abstand auf den gemeinsamen Überlappungsbereich 7a der Überlagerungseinrichtung 7 ausgerichtet werden können. Eine Drehung der Kollimationslinse 40 um die Drehachse 42 in die entgegengesetzte Richtung (Drehwinkel z.B. -0,5°) würde hingegen dazu führen, dass die Laserstrahlen 2a, ..., 2n beim Austritt aus der Transformationseinrichtung 41 divergent verlaufen.

**Fig. 16a,b** zeigen einen so genannten Dual-Emitter, bei dem genau zwei streifenförmige Laser-Emitter 4a, 4b in der SA-Richtung voneinander beabstandet auf einem gemeinsamen Laserbarren 43 strukturiert sind. Bei dem in Fig. 16a gezeigten Ausführungsbeispiel werden die von den beiden Laser-Emittern 4a, 4b erzeugten Laserstrahlen 2a, 2b mit Hilfe einer gemeinsamen FA-Kollimationslinse 27 in FA-Richtung und mit Hilfe von zwei SA-Kollimationslinsen 28a, 28b in SA-Richtung getrennt voneinander kollimiert. Ein Abstand d zwischen den Laser-Emittern 4a, 4b in SA-Richtung liegt bei dem in Fig. 16a gezeigten Beispiel in der Regel zwischen ca. 0,5 mm und ca. 2 mm.

Eine Mehrzahl von Laserbarren 43, wie sie in Fig. 16a gezeigt sind, können in der FA-Richtung (senkrecht zur Zeichenebene) übereinander gestapelt werden, wodurch sich das in Fig. 16a gezeigte Strahlprofil ergibt. Nach der in Fig. 16a mit "DWM" bezeichneten Wellenlängenkopplung in FA-Richtung ergibt sich ein Strahlprofil der überlagerten Laserstrahlen 8, welches dem Strahlaustrittsprofil eines einzelnen als Dual-Emitter ausgebildeten Laserbarrens 43 entspricht. Durch eine Überlagerung der in SA-Richtung nebeneinander angeordneten überlagerten Laserstrahlen 8 beispielsweise mit Hilfe einer in Fig. 16a mit "PK" bezeichneten Polarisationskopplungseinrichtung kann ein Strahlprofil mit einem einzigen überlagerten Laserstrahl 8 erhalten werden, dessen Strahlprofil für die Einkopplung in eine (nicht gezeigte) Lichtleitfaser geeignet ist. Es versteht sich, dass anders als bei dem in Fig. 16a gezeigten Strahlprofil der Abstand zwischen den Laserbarren 43 und damit auch der Abstand zwischen jeweils übereinander angeordneten Laserstrahlen 2a, 2b variieren können.

Bei dem in Fig. 16b gezeigten Ausführungsbeispiel wird an Stelle von zwei SA-Kollimationslinsen 28a, 28b nur eine einzige SA-Kollimationslinse 28 verwendet. Die in Fig. 16b gezeigte Anordnung hat den Vorteil, dass nur eine Linse verwendet wird und der Abstand d zwischen den beiden Laser-Emittern 4a, 4b weiter verringert werden kann, wobei typische Werte für den Abstand d im Bereich zwischen ca. 0,1 mm und 1,0 mm liegen. Ein weiterer Vorteil ergibt sich, da die gemeinsame Kollimationslinse 28 in SA-Richtung eine deutlich längere Brennweite und damit bessere Kollimation in SA-Richtung erreichen kann.

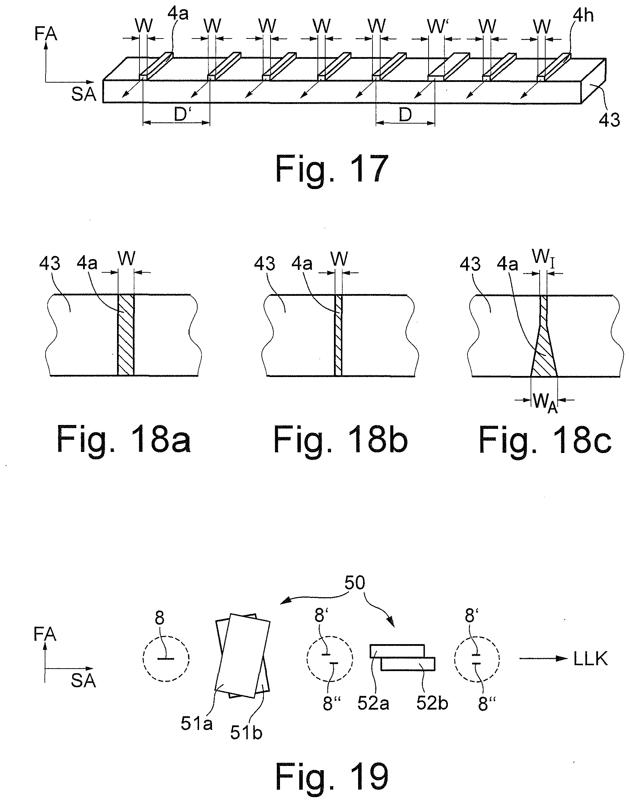

In **Fig. 17** ist ein Laserbarren 43 dargestellt, an dessen Oberseite acht streifenförmige Laser-Emitter 4a bis 4h (Laserdioden) angebracht sind. Die Laser-Emitter 4a, ..., 4h weisen jeweils eine Streifen-Breite W auf, die bis auf den sechsten Laser-Emitter 4f konstant ist und bei W = 5 μm liegt. Der sechste Laser-Emitter 4f weist eine Streifen-Breite W' von 10 μm auf. Die von den übrigen Laser-Emittern abweichende Streifen-Breite W' des sechsten Laser-Emitters 4f (und ggf. von weiteren Laser-Emittern) kann zur Veränderung des Strahlparameterprodukts genutzt werden, um dieses beispielsweise an das Strahlparameterprodukt einer Lichtleitfaser anzupassen, wie in der EP 2 088 651 A1 beschrieben ist.

Bis auf den ersten Laser-Emitter 4a und den zweiten Laser-Emitter 4b sind die Laser-Emitter in einem konstanten Abstand D voneinander angeordnet. Der Abstand D' zwischen dem ersten Laser-Emitter 4a und dem zweiten Laser-Emitter 4b ist beispielhaft größer gewählt als der (konstante) Abstand D zwischen den übrigen Laser-Emittern, um ein Übersprechen zwischen benachbarten Laser-Emittern 4b, 4c zu verhindern. Es versteht sich, dass unterschiedliche Abstände D, D' zwischen mehr als zwei, insbesondere zwischen allen Laser-Emittern 4a, ..., 4h vorgesehen werden können, um ein Übersprechen zu verhindern.

Der Füllfaktor des in Fig. 17 gezeigten Laserbarrens 43 ist definiert als die Breite W eines jeweiligen Laser-Emitters, z.B. des ersten Laser-Emitters 4a bezogen auf den Abstand D zum unmittelbar benachbarten (hier: zweiten) Laser-Emitter 4b. Bei dem in Fig. 17 gezeigten Laserbarren 43 variiert die Emitter-Breite W, W' und auch der Abstand D, D' der Laser-Emitter 4a, ..., 4h. Für die Berechnung des Füllfaktors wird der minimale Füllfaktor W / D' herangezogen, d.h. der erste Laser-Emitter 4a mit dem kleinsten Quotienten aus Emitter-Breite W und Abstand D' zum nächsten Nachbarn (dem zweiten Laser-Emitter 4b) legt den Füllfaktor W / D' des Laserbarrens 43 fest.

Der in Fig. 17 beispielhaft gezeigte Laserbarren 43 weist einen Füllfaktor W / D' von mehr als 20 %, ggf. von mehr als 25 %, insbesondere von mehr als 30 % auf. Der hohe Füllfaktor W / D' kann erreicht werden, indem eine vergleichsweise große Anzahl von Laser-Emittern 4a, ..., 4h mit einer geringen Emitter-Breite W auf dem Laserbarren 43 untergebracht wird, wobei die Abstände D zwischen den Laser-Emittern 4a, ..., 4h ebenfalls gering ausfallen. Beispielsweise kann bei einem Laserbarren 43 mit einer Gesamtbreite von ca. 10 mm und Laser-Emittern 4a, ..., 4n mit einer Breite W von nicht mehr als 10 μm bei einer Anzahl von ca. 300 Laser-Emittern 4a, ..., 4n auf dem Laserbarren 43 ein Füllfaktor W / D von ca. 25 % bis ca. 30 % erreicht werden. Wird jeder einzelne der Laser-Emitter 4a, ..., 4n mit einer Laserleistung von nur ca. 450 - 500 mW Ausgangsleistung betrieben, so ergibt sich eine Gesamtleistung von ca. 120 W pro Laserbarren 43.

Um den oben angegebenen hohen Füllfaktor zu erreichen, wird auf das Vorsehen von einzelnen SA-Kollimationslinsen verzichtet, da hierbei aufgrund eines einzuhaltenden minimalen Abstands der Array-Linsen von ca. 200 $\mu$m der Füllfaktor auf ca. 3% bis 5% limitiert war. Die Laserstrahlen einer Mehrzahl (beispielsweise von acht oder zwölf) solcher in der SA-Richtung nebeneinander angeordneter Laserbarren 43 können zur Erhöhung des Füllfaktors mit einer Überlagerungseinrichtung (z.B. mit einem Beugungs-Gitter) überlagert werden. Die Überlagerung kann beispielsweise auf die in Zusammenhang mit Fig. 1 beschriebene Weise erfolgen, wobei ein in Fig. 1 gezeigter Laser-Emitter 4a, ..., 4n jeweils einem der Laserbarren 43 entspricht.

Alternativ können beispielsweise eine SA-Transformationslinse - ggf. in Kombination mit einem in SA-Richtung wirkenden Strahlteleskop - verwendet werden, um die Laserstrahlen eines Laserbarrens 43 oder mehrerer der Laserbarren 43 auf die Überlagerungseinrichtung z.B. in Form des winkeldispersiven optischen Elements 7 zu fokussieren und die Rückkopplungseffizienz zu erhöhen. Das in SA-Richtung wirkende Strahlteleskop kann beispielsweise zwei Zylinderlinsen aufweisen, die im Strahlweg vor der in SA-Richtung wirkenden Transformationslinse angeordnet sind, welche ebenfalls als Zylinderlinse ausgebildet sein kann. Aufgrund der sehr guten Strahlqualität bei der Überlagerung in SA-Richtung kann ein nahezu beugungsbegrenzter überlagerter Laserstrahl generiert werden. Dieser zeichnet sich durch eine Beugungsmesszahl $M^2$ (s.u.) kleiner 3, bevorzugt kleiner 2 aus. Dies führt zu einer Gesamtleistung der Anordnung bzw. Vorrichtung 1 von ca. 1 kW.

Wie weiter oben ausgeführt, ist gegenüber einem herkömmlichen Breitstreifen-Emitter 4a mit einer Emitter-Breite W von mehr als 10 $\mu$m, wie er beispielhaft in **Fig. 18a** dargestellt ist, die Emitter-Breite W bei einem Laser-Emitter 4a, ..., 4h (Streifenemitter) des Laserbarrens 43 reduziert (vgl. **Fig. 18b**), d.h. dieser weist eine Breite W von 10 $\mu$m oder weniger, insbesondere von 5 $\mu$m oder weniger auf. Bei Laser-Emittern 4a, ..., 4h mit derart geringer lateraler Ausdehnung W handelt es sich typischer Weise um so genannte Single-Mode-Emitter, deren spektrale Bandbreite sich aufgrund des aus der geringen Breite resultierenden Strahlparameterprodukts - zumindest theoretisch - auf eine extrem schmale Linienbreite im Pikometer-Bereich stabilisieren lässt.

Ein Maß für die Fokussierbarkeit bzw. Strahlqualität stellt die (dimensionslose) Beugungsmaßzahl $M^2$ (hier: in SA-Richtung) dar, welche den Divergenzwinkel eines Laserstrahls im Vergleich zur Divergenz eines idealen Gaußstrahls mit gleichem Durchmesser an der Strahltaille bezeichnet. Je größer die (zum Strahlparameterprodukt proportionale) Beugungsmaßzahl $M^2$ ist, desto schlechter ist der Laserstrahl zu fokussieren. Ein Gaußstrahl hat die Beugungsmaßzahl $M^2$ = 1,0. Für die vorliegende Anwendung, d.h. für das Erreichen eines hohen Füllfaktors W / D' von mehr als 25 % weisen die einzelnen Laser-Emitter 2a, ..., 2n des Laserbarrens 43 typischer Weise eine Beugungsmaßzahl $M^2$ in SA-Richtung von weniger als 2,0, von weniger als 1,5, insbesondere von weniger als 1,3 auf. Bei Laser-Emittern 2a, ..., 2n mit einer solchen Beugungsmaßzahl $M^2$ in SA-Richtung handelt es sich (näherungsweise) um Single-Mode-Emitter, die wie oben angegeben auf eine extrem schmale Linienbreite spektral stabilisiert werden können, was sich signifikant auf die spektrale Brillanz auswirkt.

Durch die spektrale Stabilisierung auf eine sehr geringe Linienbreite nimmt die Anzahl an durch eine Wellenlängen-Überlagerung in SA-Richtung koppelbaren Laser-Emittern 4a, ..., 4h pro Laserbarren 43 zu, so dass trotz abnehmender Leistung pro Laser-Emitter 4a, ..., 4h eine hohe Ausgangsleistung pro Wellenlängenband erreicht werden kann. Ein weiterer positiver Effekt, der sich aus der Reduzierung der emittierenden Fläche pro Emitter ergibt, ist die Verbesserung der Strahlqualität. Bei der Verwendung des Laserbarrens 43 von Fig. 17 kann die spektrale Bandbreite gegenüber herkömmlichen Breitstreifen-Emitter, die in der Regel eine Bandbreite von ca. 0,3 nm bis 0,4 nm aufweisen, deutlich reduziert werden, beispielsweise auf ca. 0,1 nm oder weniger.

Neben den weiter oben beschriebenen Single-Mode-Emittern mit konstanter Streifenbreite W können die oben angegebenen Werte für die Beugungsmaßzahl $M^2$ auch mit einem in **Fig. 18c** gezeigten Trapezlaser-Emitter 4a erzeugt werden, bei dem auf einem Halbleiter-Chip sowohl ein schmaler Streifen konstanter Breite $W_l$, der einen Monomode-Seedbereich bildet, als auch ein sich in Richtung zur Strahlaustrittsfläche trapezförmig erweiternder Verstärkerbereich mit maximaler Breite $W_A$ anschließt. Ein Emitter mit einer Beugungsmaßzahl $M^2$ im oben angegebenen Wertebereich kann auch in Form eines so genannten Z-Lasers oder als Oberflächen-Emitter (z.B. VCSEL, VECSEL) ausgebildet sein.

**Fig. 19** zeigt eine Strahlformungseinrichtung 50, welche zur Formung eines Strahlprofils dient, das im vorliegenden Beispiel aus einem einzigen überlagerten Laserstrahl 8 besteht. Die Formung des Strahlprofils ist günstig, um die Effektivität der Einkopplung der von der Vorrichtung 1 erzeugten Laserstrahlung in eine Lichtleitfaser "LLK" zu erhöhen. Zur Formung des Strahlprofils weist die Strahlformungseinrichtung 50 eine Strahlteilereinrichtung auf, welche aus zwei unter einem Winkel relativ zueinander angeordneten transmittierenden Platten 51a, 51b besteht, die den überlagerten Laserstrahl 8 in zwei Teilstrahlen 8', 8" zerschneiden und diese in FA-Richtung zueinander zu versetzen, wie in Fig. 20 zu erkennen ist.

Die beiden in FA-Richtung zueinander versetzten Teilstrahlen 8', 8" werden mit Hilfe einer Einrichtung zur räumlichen Umordnung der Teilstrahlen 8', 8", die im vorliegenden Beispiel durch einen zweiten Stapel mit zwei gegeneinander verdrehten Platten 52a, 52b gebildet ist, der gegenüber den ersten beiden Platten 51a, 51b um 90° verdreht ist, in SA-Richtung zueinander versetzt. Auf diese Weise wird ein Strahlprofil erzeugt, bei dem die beiden Teilstrahlen 8', 8" in FA-Richtung übereinander gestapelt sind, wie in Fig. 20 ebenfalls zu erkennen ist. Alternativ zu Verwendung einer Strahlteilereinrichtung in Form der beiden ersten Platten 51a, 51b kann ein Zerschneiden des überlagerten Laserstrahls 8 auch durch einen Loch- oder Kantenspiegel erfolgen oder es können zwei Platten mit parallelen Spiegelflächen verwendet werden, wie in der US 5,825,551 beschrieben ist.

Auch die räumliche Umordnung der Teilstrahlen bzw. von mehreren überlagerten Laserstrahlen (bei einem entsprechenden Strahlprofil mit mehreren überlagerten Laserstrahlen) kann nicht nur mit Hilfe der einer Mehrzahl von gegeneinander verdrehten Platten 52a, 52b erfolgen, es können zu diesem Zweck beispielsweise auch Treppenspiegel eingesetzt werden. Zusätzlich oder alternativ zur räumlichen Umordnung kann auch eine Überlagerung von zwei oder mehr überlagerten Laserstrahlen 8 bzw. Teilstrahlen 8', 8" erfolgen, z.B. mit Hilfe einer Polarisationskopplungseinrichtung in der Art eines dielektrischen Spiegels oder dergleichen. Die Einrichtung zur Überlagerung, beispielsweise in der Form eines Polarisationskopplers, führt die beiden überlagerten Laserstrahlen bzw. Teilstrahlen 8', 8" zu einem Laserstrahl zusammen.

Es kann auch eine Transformationseinrichtung zur Veränderung bzw. zur Drehung der Orientierung eines oder mehrerer der überlagerten Laserstrahlen als Komponente der Strahlformungseinrichtung vorgesehen sein. Beispielsweise kann auf diese Weise die Orientierung des bzw. der überlagerten Laserstrahl(en) 8 bzw. der Teilstrahlen 8', 8" um 90° gedreht werden, so dass eine horizontale Orientierung des Strahlquerschnitts eines überlagerten Laserstrahls 8 bzw. Teilstrahls 8', 8" in eine vertikale Orientierung umgewandelt werden kann oder umgekehrt.

Alternativ zur Verwendung der Platten 51a, 51b können als Strahlteilereinrichtung zur Erzeugung von zwei oder mehr Teilstrahlen 8', 8" aus dem überlagerten Laserstrahl 8 auch eine oder mehrere trapezförmige Platten dienen. Die trapezförmigen Platten oder ggf. ein Platte, die zwei oder mehr trapezförmige Segmente aufweist, auf welche der überlagerte Laserstrahl 8 auftrifft, ermöglicht es, den überlagerten Laserstrahl 8 ohne Kantenverluste in zwei oder mehr Teilstrahlen 8', 8" zu zerschneiden. Die Teilstrahlen 8', 8" können dann z.B. mittels eines optischen Rotators oder eines Treppenspiegels zu einem bezüglich der Strahlqualität symmetrischen Strahlprofil umgeordnet werden.

Wie weiter oben dargestellt wurde, kann der bzw. können die überlagerten Laserstrahlen 8 (bzw. Teilstrahlen 8', 8") in die Lichtleitfaser LLK eingekoppelt werden und direkt bzw. über eine geeignete Strahlführung zur Materialbearbeitung genutzt werden. Gegebenenfalls kann die Laserstrahlung auch zum Pumpen eines weiteren Lasers, beispielsweise eines Festkörperlasers, genutzt werden, der ebenfalls zur Materialbearbeitung oder für andere Anwendungen (Markieren, etc.) eingesetzt werden kann. Die Strahlführung der Pumpstrahlung kann über Absorber, Strahlweichen, Strahlteiler etc. erfolgen. Auch ist es möglich, die Leistung der von der Vorrichtung 1 gelieferten Laserstrahlung zu messen und diese ggf. zu regeln.

## Patentansprüche

1. Vorrichtung (1) zur Wellenlängenkopplung von Laserstrahlen (2a, ..., 2n) mit unterschiedlichen Wellenlängen ($\lambda_1$, ..., $\lambda_n$), umfassend:

   mindestens eine Laserquelle (3) zur Erzeugung einer Mehrzahl von Laserstrahlen (2a, ..., 2n), sowie
   eine Überlagerungseinrichtung (7) zur räumlichen Überlagerung der Mehrzahl von Laserstrahlen (2a, ..., 2n) zur Bildung eines überlagerten Laserstrahls (8) mit mehreren Wellenlängen ($\lambda_1$, ..., $\lambda_n$), weiter umfassend:

   eine im Strahlweg des überlagerten Laserstrahls (8) angeordnete Rückkopplungseinrichtung (12) zur Rückkopplung eines Strahlungsanteils des überlagerten Laserstrahls (8) zurück zur Laserquelle (3), wobei die Rückkopplungseinrichtung als Auskoppelelement (12) mit einer den überlagerten Laserstrahl (8) teilweise reflektierenden Oberfläche (12a) ausgebildet ist **dadurch gekennzeichnet, dass** die Vorrichtung (1) eine Phasenkorrektureinrichtung (12, 15) zur Phasenkorrektur des zur Laserquelle (3) zurück reflektierten Strahlungsanteils aufweist, und dass die teilweise reflektierende Oberfläche (12a) des Auskoppelelements (12) eine Krümmung aufweist.

2. Vorrichtung nach Anspruch 1, bei welcher die Überlagerungseinrichtung als Beugungs-Gitter (7) ausgebildet ist, welches zur Veränderung der Wellenlängen ($\lambda_1$, ..., $\lambda_n$) der zu überlagernden Laserstrahlen (2a, ..., 2n) um eine Drehachse (19) drehbar gelagert ist.

3. Vorrichtung nach Anspruch 1 oder 2, bei welcher im Strahlweg zwischen der Lichtquelle (3) und der Rückkopplungseinrichtung (12), bevorzugt im Strahlweg zwischen der Überlagerungseinrichtung (7) und der Rückkopplungseinrichtung (12), ein Polarisationsfilter (16) angeordnet ist.

4.  Vorrichtung nach Anspruch 3, bei welcher der Polarisationsfilter (16) und die Überlagerungseinrichtung (7) oder der Polarisationsfilter (16) und die Rückkopplungseinrichtung (12) als gemeinsames optisches Element ausgebildet sind.

5.  Vorrichtung nach einem der vorhergehenden Ansprüche, bei welcher ein Phasenkorrekturelement der Phasenkorrektureinrichtung und die Rückkopplungseinrichtung als gemeinsames optisches Element (12) ausgebildet sind.

6.  Vorrichtung nach einem der vorhergehenden Ansprüche, bei welcher das Auskoppelelement (12) zur Strahlformung des ausgekoppelten überlagerten Laserstrahls (8a) ausgebildet ist.

7.  Vorrichtung nach einem der vorhergehenden Ansprüche, bei welcher die Phasenkorrektureinrichtung ein abbildendes optisches Element (15) zur Kollimation des überlagerten Laserstrahls (8) auf die teilweise reflektierende, plane Oberfläche (12a) des Auskoppelelements (12) aufweist, wobei der Krümmungsradius ($R_K$) des abbildenden optischen Elements (15) an den Radius ($R_P$) der Phasenkrümmung des überlagerten Laserstrahls (8) angepasst ist.

8.  Vorrichtung nach einem der vorhergehenden Ansprüche, bei welcher die Überlagerungseinrichtung (7) und die Rückkopplungseinrichtung, insbesondere das Auskoppelelement (12), als ein gemeinsames optisches Element (17) ausgebildet sind.

9.  Vorrichtung nach einem der vorhergehenden Ansprüche, weiter umfassend: ein erstes im Strahlweg zwischen der Laserquelle (3) und der Überlagerungseinrichtung (7) angeordnetes abbildendes optisches Element (13a), welches gemeinsam mit einem zweiten im Strahlweg zwischen der Laserquelle (3) und der Überlagerungseinrichtung (7) angeordneten abbildenden optischen Element (13b) ein Strahlteleskop (13a, 13b) bildet.

10. Vorrichtung nach einem der vorhergehenden Ansprüche, weiter umfassend: ein im Strahlweg zwischen der Laserquelle (3) und der Überlagerungseinrichtung (7) angeordnetes abbildendes optisches Element (5), welches gemeinsam mit einem im Strahlweg des überlagerten Laserstrahls (8) angeordneten abbildenden optischen Element (13) ein Strahlteleskop (5, 13) bildet.

11. Vorrichtung nach einem der vorhergehenden Ansprüche, weiter umfassend: eine Strahlumlenkungseinrichtung (20) zur Ausrichtung der zu überlagernden Laserstrahlen (2a, ..., 2n) auf einen gemeinsamen Überlappungsbereich (7a) der Überlagerungseinrichtung (7) oder der Rückkopplungseinrichtung (6).

12. Vorrichtung nach Anspruch 11, bei welcher die Strahlumlenkungseinrichtung mindestens ein Facettenelement (20) mit einer Mehrzahl von Facetten (20a) zur Ausrichtung eines jeweiligen Laserstrahls (2a, ..., 2n) auf den gemeinsamen Überlappungsbereich (7a) aufweist.

13. Vorrichtung nach Anspruch 11 oder 12, bei welcher die Strahlumlenkungseinrichtung eine Mehrzahl von Umlenkspiegeln (22a, ..., 22n) zur Ausrichtung der Laserstrahlen (2a, ..., 2n) auf den gemeinsamen Überlappungsbereich (7a) aufweist.

14. Vorrichtung nach einem der vorhergehenden Ansprüche, weiter umfassend: eine Transformationseinrichtung (41) zur Umordnung der Laserstrahlen (2a, ..., 2n) der Laserquelle (3) und/oder zur Drehung der Orientierung der Laserstrahlen (2a, ..., 2n) der Laserquelle (3).

15. Vorrichtung nach Anspruch 14, bei welcher eine Kollimationslinse (40) zur Kollimation von mehreren in einer gemeinsamen Ebene (X, Y) verlaufenden, von der Laserquelle (3) emittierten Laserstrahlen (2a, ..., 2n) unter einem Winkel ($\varphi$) zu der gemeinsamen Ebene (X, Y) angeordnet ist und wobei die Kollimationslinse (40) gemeinsam mit der zur Drehung der Orientierung der Laserstrahlen (2a, ..., 2n) ausgebildeten Transformationseinrichtung (41) eine Ausrichtung der Laserstrahlen (2a, ..., 2n) auf einen gemeinsamen Überlappungsbereich (7a) bewirkt.

**Claims**

1.  A device (1) for wavelength coupling of laser beams (2a, ..., 2n) with different wavelengths ($\lambda_1$ ..., $\lambda_n$), comprising: at least one laser source (3) for generating a plurality of laser beams (2a, .., 2n) and an overlapping device (7) for spatial overlapping of the plurality of laser beams (2a, ..., 2n) for forming an overlapped laser beam (8) with a plurality of wavelengths ($\lambda_1$, ... $\lambda_n$), further comprising:

a feedback device (12) arranged in the beam path of the overlapped laser beam (8) for feeding a radiation proportion of the overlapped laser beam (8) back to the laser source (3), wherein the feedback device is configured as an output coupling element (12) with a surface (12a) partially reflecting the overlapped laser beam (8), **characterized in that** the device (1) comprises a phase correction device (12, 15) for phase correction of the radiation proportion reflected back to the laser source (3), and that the partially reflecting surface (12a) of the output coupling element (12) has a curvature.

2. The device according to claim 1, wherein the overlapping device is configured as a diffraction grating (7) which is rotatably mounted about an axis of rotation (19) for altering the wavelengths ($\lambda_1$..... $\lambda_n$) of the laser beams (2a, ..., 2n) to be overlapped.

3. The device according to claim 1 or 2, wherein a polarisation filter (16) is arranged in the beam path between the light source (3) and the feedback device (12), preferably in the beam path between the overlapping device (7) and the feedback device (12).

4. The device according to claim 3, wherein the polarisation filter (16) and the overlapping device (7) or the polarisation filter (16) and the feedback device (12) are configured as a common optical element.

5. The device according to any one of the preceding claims, wherein a phase correction element of the phase correction device and the feedback device are configured as a

6. The device according to any one of the preceding claims, wherein the output coupling element (12) is configured for beam forming the outcoupled overlapped laser beam (8a).

7. The device according to any one of the preceding claims, wherein the phase correction device has an imaging optical element (15) for the collimation of the overlapped laser beam (8) to the partially reflecting, flat surface (12a) of the output coupling element (12), wherein the radius of curvature ($R_K$) of the imaging optical element (15) is adapted to the radius (Rp) of the phase curvature of the overlapped laser beam (8).

8. The device according to any one of the preceding claims, wherein the overlapping device (7) and the feedback device, in particular the output coupling element (12), are configured as a common optical element (17).

9. The device according to any one of the preceding claims, further comprising: a first imaging optical element (13a) arranged in the beam path between the laser source (3) and the overlapping device (7), which element, together with a second imaging optical element (13b) arranged in the beam path between the laser source (3) and the overlapping device (7), forms a beam telescope (13a, 13b).

10. The device according to any one of the preceding claims, further comprising: an imaging optical element (5) arranged in the beam path between the laser source (3) and the overlapping device (7), which element, together with an imaging optical element (13) arranged in the beam path of the overlapped laser beam (8), forms a beam telescope (5, 13).

11. The device according to any one of the preceding claims, further comprising: a beam deflection device (20) for aligning the laser beams (2a, ..., 2n) to be overlapped to a common overlapping area (7a) of the overlapping device (7) or of the feedback device (6).

12. The device according to claim 11, wherein the beam deflection device has at least one facet element (20) with a plurality of facets (20a) for aligning a respective laser beam (2a, ..., 2n) to the common overlapping area (7a).

13. The device according to claim 11 or 12, wherein the beam deflection device has a plurality of deflection mirrors (22a, .., 22n) for aligning the laser beams (2a, ..., 2n) to the common overlapping area (7a).

14. The device according to any one of the preceding claims, further comprising: a transformation device (41) for rearranging the laser beams (2a, ..., 2n) of the laser source (3) and/or for rotating the orientation of the laser beams (2a, ..., 2n) of the laser source (3).

15. The device according to claim 14, wherein a collimation lens (40) for collimating a plurality of laser beams (2a, ...,

2n) running in a common plane (X, Y) and emitted by the laser source (3) is arranged at an angle ($\varphi$) to the common plane (X, Y), and wherein the collimation lens (40) together with the transformation device (41) designed for rotating the orientation of the laser beams (2a, ..., 2n) effects an alignment of the laser beams (2a, ..., 2n) to a common overlapping area (7a).

**Revendications**

1. Dispositif (1) de couplage de longueurs d'onde de faisceaux laser (2a, ..., 2n) ayant des longueurs d'onde différentes ($\lambda_1$, ..., $\lambda_n$), comprenant :

   au moins une source laser (3) pour générer une pluralité de faisceaux laser (2a, ..., 2n) et
   un moyen de superposition (7) pour superposer spatialement la pluralité de faisceaux laser (2a, ..., 2n) pour former un faisceau laser superposé (8) ayant plusieurs longueurs d'onde ($\lambda_1$, ..., $\lambda_n$), comprenant en outre :

      un moyen de rétrocouplage (12) disposé dans le trajet de faisceau du faisceau laser superposé (8) pour rétrocoupler une fraction de rayonnement du faisceau laser superposé (8) vers la source laser (3), le moyen de rétrocouplage étant réalisé sous la forme d'un élément de découplage (12) ayant une surface (12a) réfléchissant partiellement le faisceau laser superposé (8),
      **caractérisé en ce**
      **que** le dispositif (1) présente un moyen de correction de phase (12, 15) pour corriger la phase de la fraction de rayonnement réfléchie vers la source laser (3), et en ce que la surface partiellement réfléchissante (12a) de l'élément de découplage (12) présente une courbure.

2. Dispositif selon la revendication 1, dans lequel le moyen de superposition est réalisé sous la forme d'un réseau de diffraction (7) qui est monté rotatif autour d'un axe de rotation (19) pour changer les longueurs d'onde ($\lambda_1$, ..., $\lambda_n$) des faisceaux laser (2a, ..., 2n) à superposer.

3. Dispositif selon la revendication 1 ou 2, dans lequel un filtre de polarisation (16) est disposé dans le trajet de faisceau entre la source lumineuse (3) et le moyen de rétrocouplage (12), de préférence dans le trajet de faisceau entre le moyen de superposition (7) et le moyen de rétrocouplage (12).

4. Dispositif selon la revendication 3, dans lequel le filtre de polarisation (16) et le moyen de superposition (7) ou le filtre de polarisation (16) et le moyen de rétrocouplage (12) sont réalisés sous la forme d'un élément optique commun.

5. Dispositif selon l'une des revendications précédentes, dans lequel un élément de correction de phase du moyen de correction de phase et le moyen de rétrocouplage sont réalisés sous la forme d'un élément optique commun (12).

6. Dispositif selon l'une des revendications précédentes, dans lequel l'élément de découplage (12) est conçu pour mettre en forme le faisceau laser superposé découplé (8a).

7. Dispositif selon l'une des revendications précédentes, dans lequel le moyen de correction de phase présente un élément optique de formation d'image (15) pour collimater le faisceau laser superposé (8) sur la surface plane partiellement réfléchissante (12a) de l'élément de découplage (12), le rayon de courbure ($R_K$) de l'élément optique de formation d'image (15) étant adapté au rayon ($R_P$) de la courbure de phase du faisceau laser superposé (8).

8. Dispositif selon l'une des revendications précédentes, dans lequel le moyen de superposition (7) et le moyen de rétrocouplage, en particulier l'élément de découplage (12), sont réalisés sous la forme d'un élément optique commun (17).

9. Dispositif selon l'une des revendications précédentes, comprenant en outre : un premier élément optique de formation d'image (13a) disposé dans le trajet de faisceau entre la source laser (3) et le moyen de superposition (7), qui, conjointement avec un deuxième élément optique de formation d'image (13b) disposé dans le trajet de faisceau entre la source laser (3) et le moyen de superposition (7), forme un télescope de faisceau (13a, 13b).

10. Dispositif selon l'une des revendications précédentes, comprenant en outre : un élément optique de formation d'image (5) disposé dans le trajet de faisceau entre la source laser (3) et le moyen de superposition (7), qui, conjointement avec un élément optique de formation d'image (13) disposé dans le trajet de faisceau du faisceau laser superposé (8), forme un télescope de faisceau (5, 13).

11. Dispositif selon l'une des revendications précédentes, comprenant en outre : un moyen de déviation de faisceau (20) pour orienter les faisceaux laser (2a, ..., 2n) à superposer vers une zone de recouvrement commune (7a) du moyen de superposition (7) ou du moyen de rétrocouplage (6).

12. Dispositif selon la revendication 11, dans lequel le moyen de déviation de faisceau présente au moins un élément à facettes (20) ayant une pluralité de facettes (20a) pour orienter un faisceau laser respectif (2a, ..., 2n) vers la zone de recouvrement commune (7a).

13. Dispositif selon la revendication 11 ou 12, dans lequel le dispositif de déviation de faisceau présente une pluralité de miroirs de déviation (22a, ..., 22n) pour orienter les faisceaux laser (2a, ..., 2n) vers la zone de recouvrement commune (7a).

14. Dispositif selon l'une des revendications précédentes, comprenant en outre : un moyen de transformation (41) pour réarranger les faisceaux laser (2a, ..., 2n) de la source laser (3) et/ou pour faire tourner l'orientation des faisceaux laser (2a, ..., 2n) de la source laser (3).

15. Dispositif selon la revendication 14, dans lequel une lentille de collimation (40) pour collimater plusieurs faisceaux laser (2a, ..., 2n) émis par la source laser (3) et s'étendant dans un plan commun (X, Y) est disposée selon un angle ($\varphi$) par rapport au plan commun (X, Y) et dans lequel la lentille de collimation (40) produit, conjointement avec le moyen de transformation (41) conçu pour faire tourner l'orientation des faisceaux laser (2a, ..., 2n), une orientation des faisceaux laser (2a, ..., 2n) vers une zone de recouvrement commune (7a).

Fig. 1

Fig. 2

Fig. 3

28

Fig. 4a

Fig. 4b

Fig. 5a

Fig. 5b

Fig. 5c

**Fig. 6a**

**Fig. 6b**

**Fig. 7a**

**Fig. 7b**

Fig. 8

Fig. 9

Fig. 10

31

Fig. 11a

Fig. 11b

Fig. 11c

Fig. 12a

Fig. 12b

Fig. 12c

Fig. 13

Fig. 14

Fig. 15a

Fig. 15b

Fig. 16a

Fig. 16b

**Fig. 17**

**Fig. 18a**   **Fig. 18b**   **Fig. 18c**

**Fig. 19**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2523280 A2
- US 6192062 B1
- WO 2006116477 A2
- US 8049966 B2
- EP 2088651 A1
- EP 1619765 A1
- US 20110216417 A1
- US 20110216792 A1
- US 20110222574 A1
- EP 1601072 A1
- DE 102011016253 A1
- EP 2342597 B1
- US 5825551 A
- US 5513201 A

**In der Beschreibung aufgeführte Nicht-Patentliteratur**

- **VON B. CHANN et al.** High-Power Near-Diffraction-Limited Wavelength-Beam-Combined Diode Arrays. *Conference on Lasers & Electro-Optics (CLEO),* 2005, 431-433
- **VON N. LICHTENSTEIN et al.** Singlemode Emitter Array Laser Bars for High-Brightness Applications. *IEEE 19th International Semiconductor Laser Conference,* 2004, 45-46